# EUROPEAN PATENT APPLICATION

(11) **EP 4 808 336 A1**
(43) Date of publication of application: **16.09.2026**
(21) Application number: 26150226.4
(22) Date of filing: 05.01.2026
(51) Int. Cl.: H10P 72/00

(54) **SUBSTRATE PROCESSING METHOD AND SUBSTRATE PROCESSING APPARATUS**

(30) Priority: 12.03.2025 JP 2025039381
(71) Applicant: SCREEN Holdings Co., Ltd., Kyoto-shi, Kyoto 602-8585 (JP)
(72) Inventor: FUGANE, Keisuke, Kyoto, 602-8585 (JP)
(74) Representative: Kilian Kilian & Partner mbB

(57) **Abstract**

The present invention relates to a substrate processing method and a substrate processing apparatus. The substrate processing method includes a treating step, a replacing step, and a pressure restoration step. In the treating step, a treating gas is supplied to a treatment space. The treatment space accommodates a substrate. In the replacing step, a pressure in the treatment space is kept lower than atmospheric pressure. In the replacing step, an inert gas is supplied to the treatment space. In the replacing step, a gaseous body is exhausted from the treatment space. In the pressure restoration step, the pressure in the treatment space returns to the atmospheric pressure. A flow rate of the inert gas supplied to the treatment space is a supply flow rate. A flow rate of the gaseous body exhausted from the treatment space is an exhaust flow rate. In the replacing step, at least either the supply flow rate or the exhaust flow rate changes with time.

## Description

### BACKGROUND OF THE INVENTION

### 1. TECHNICAL FIELD

This invention relates to a substrate processing method and a substrate processing apparatus for processing a substrate. A substrate is, for example, any of a semiconductor wafer, a liquid crystal display substrate, an organic electroluminescence (OEL) substrate, a flat panel display (FPD) substrate, an optical display substrate, a magnetic disk substrate, an optical disk substrate, a magneto-optical disk substrate, a photomask substrate, and a solar cell substrate.

### 2. DESCRIPTION OF THE RELATED ART

JP 2017-147391 A discloses a substrate processing method. The substrate processing method disclosed in JP 2017-147391 A includes a treating step, a replacing step, and a pressure restoration step.

In the treating step, a treating gas is supplied to a treatment space. In the treating step, the treating gas is supplied to a substrate in the treatment space. The treating gas contains, for example, hexamethyldisilazane. Hexamethyldisilazane is referred to as "HMDS" as appropriate.

In the replacing step, an inert gas is supplied to the treatment space, and a gaseous body is exhausted from the treatment space. In the replacing step, the treating gas in the treatment space is replaced with the inert gas.

In the pressure restoration step, an inert gas is supplied to the treatment space. In the pressure restoration step, a pressure in the treatment space returns to atmospheric pressure.

### SUMMARY OF THE INVENTION

It may be difficult to appropriately replace the treating gas in the treatment space with the inert gas in the replacing step. In other words, it may be difficult to sufficiently exhaust the treating gas from the treatment space in the replacing step. For example, a trace amount of the treating gas may remain in the treatment space after the replacing step.

This may result in leakage of the treating gas from the treatment space. For example, when the substrate is carried out of the treatment space, the treating gas may leak from the treatment space. If the treating gas leaks, the treating gas may react to produce a reaction product. For example, HMDS may hydrolyze to ammonia and trimethylsilanol. The reaction product may deteriorate at least either the quality of the substrate or the quality of treatment performed on the substrate.

For example, the treating gas may leak to "another space" other than the treatment space. The "other space" is, for example, a transport space for transporting the substrate. When the treating gas leaks into the "other space", the substrate may be contaminated in the "other space". When the substrate is contaminated, the quality of the substrate deteriorates.

For example, the treating gas may reach "another equipment" disposed outside the treatment space. When the treating gas reaches the "other equipment", the "other equipment" may be contaminated. The "other equipment" is, for example, an exposure machine for exposing the substrate. For example, a lens of the exposure machine may become dirty. When the "other equipment" is contaminated, the quality of treatment performed on the substrate by the "other equipment" deteriorates.

The present invention has been made in view of such circumstances, and an object thereof is to provide a substrate processing method and a substrate processing apparatus for appropriately replacing a treating gas with an inert gas.

The inventor analyzed a flow of the gaseous body in the treatment space in the replacing step. As a result, the first matter has been found.

First matter: In a replacing step, a local concentration of a treating gas may not uniformly decrease throughout a treatment space. In the replacing step, the local concentration of the treating gas may become nonuniform throughout the treatment space.

Here, the "local concentration of the treating gas" is the concentration of the treating gas in a gaseous body in a local area. The local area is a part of the treatment space.

For example, in the replacing step, the treatment space may be divided into a low-concentration area and a high-concentration area. Each of the low-concentration area and the high-concentration area is the local area of the treatment space. The high-concentration area may be adjacent to the low-concentration area. Examples of the local concentration of the treating gas include the concentration of the treating gas in the low-concentration area and the concentration of the treating gas in the high-concentration area.

The concentration of the treating gas in the low-concentration area is lower than the concentration of the treating gas in the high-concentration area. Therefore, in the low-concentration area, it is easy to appropriately replace the treating gas with an inert gas. In other words, it is easy to sufficiently exclude the treating gas from the low-concentration area.

Even in the high-concentration area, most of the treating gas in the high-concentration area is replaced with the inert gas. However, the concentration of the treating gas in the high-concentration area is not sufficiently low. This makes it difficult to appropriately replace the treating gas with the inert gas in the high-concentration area. In other words, it is difficult to sufficiently exclude the treating gas from the high-concentration area. Thus, at least in the high-concentration area, the above-described object is not achieved.

Furthermore, the second matter has been found.

Second matter: Even if the time length of the replacing step is increased, it may be difficult to make the local concentrations of the treating gas uniform throughout the treatment space.

For example, even if the time length of the replacing step is increased, the high-concentration area may still remain. Even if the time length of the replacing step is increased, it may be difficult to sufficiently lower the concentration of the treating gas in the high-concentration area. Even if the time length of the replacing step is increased, it may be difficult to reduce a difference in the local concentration of the treating gas between the high-concentration area and the low-concentration area. Even if the time length of the replacing step is increased, it may be difficult to diffuse the treating gas in the high-concentration area into the low-concentration area. This makes it difficult to appropriately replace the treating gas with the inert gas in the high-concentration area even if the time length of the replacing step is increased. In other words, even if the time length of the replacing step is increased, it is difficult to sufficiently exclude the treating gas from the high-concentration area. Therefore, it is difficult to achieve the above-described object even if the time length of the replacing step is increased.

Hence, the inventor has further intensively studied means for achieving the above object.

The present invention is based on the above analysis, findings, and study. The present invention has the following configuration. That is, the present invention is a substrate processing method including: a treating step of supplying a treating gas to a treatment space accommodating a substrate; a replacing step of supplying an inert gas to the treatment space and exhausting a gaseous body from the treatment space in a state where a pressure in the treatment space is kept lower than atmospheric pressure; and a pressure restoration step of restoring the pressure in the treatment space to the atmospheric pressure, wherein a flow rate of the inert gas supplied to the treatment space is defined as a supply flow rate, a flow rate of the gaseous body exhausted from the treatment space is defined as an exhaust flow rate, and in the replacing step, at least either the supply flow rate or the exhaust flow rate changes with time.

In other words, the present invention is a substrate processing method including:
supplying a treating gas to a treatment space accommodating a substrate;
replacing the treating gas in the treatment space with an inert gas; and
restoring a pressure in the treatment space to atmospheric pressure, wherein
replacing the treating gas with the inert gas includes supplying the inert gas to the treatment space and exhausting a gaseous body from the treatment space in a state where the pressure in the treatment space is kept lower than the atmospheric pressure,
a flow rate of the inert gas supplied to the treatment space is defined as a supply flow rate,
a flow rate of the gaseous body exhausted from the treatment space is defined as an exhaust flow rate, and
in replacing the treating gas with the inert gas, at least either the supply flow rate or the exhaust flow rate changes with time.

The substrate processing method includes the treating step, the replacing step, and the pressure restoration step. In the treating step, the treating gas is supplied to the treatment space. The treatment space accommodates the substrate. Therefore, in the treating step, the treating gas is supplied to the substrate. In the replacing step, the pressure in the treatment space is lower than the atmospheric pressure. That is, in the replacing step, the pressure in the treatment space is kept lower than the atmospheric pressure. In the replacing step, the inert gas is supplied to the treatment space. In the replacing step, the gaseous body is exhausted from the treatment space. The Gaseous body is rephrased as a gas. In the pressure restoration step, the pressure in the treatment space returns to the atmospheric pressure.

The "supply flow rate" is the flow rate of the inert gas supplied to the treatment space. The "exhaust flow rate" is the flow rate of the gaseous body exhausted from the treatment space. In the replacing step, at least either the supply flow rate or the exhaust flow rate changes with time. In other words, at least either the supply flow rate or the exhaust flow rate changes temporally. In other words, at least either the supply flow rate or the exhaust flow rate changes time-dependently. In other words, at least either the supply flow rate or the exhaust flow rate changes as time passes. Therefore, the intensity of a flow of the gaseous body in the treatment space changes with time. Here, the temporal change of the intensity of the flow of the gaseous body in the treatment space promotes diffusion of the treating gas in the treatment space. The temporal change is rephrased as the change over time. The temporal change is rephrased as the time-dependent change. This makes it easy for the treating gas to diffuse throughout the treatment space in the replacing step. It is difficult for the treating gas to stay in the local area of the treatment space in the replacing step. Therefore, it is easy to make the local concentrations of the treating gas uniform throughout the treatment space in the replacing step. It is easy to reduce the difference between the local concentrations of the treating gas in the replacing step. As a result, it is easy to appropriately replace the treating gas in the treatment space with the inert gas in the replacing step. It is easy to sufficiently exhaust the treating gas from the treatment space in the replacing step.

In summary, the substrate processing method appropriately replaces the treating gas with the inert gas.

It is preferred in the substrate processing method that at least either the supply flow rate or the exhaust flow rate temporarily changes to zero in the replacing step. In other words, it is preferred in the substrate processing method that at least either the supply flow rate or the exhaust flow rate changes to zero for a portion of the time of the replacing step. In other words, it is preferred in the substrate processing method that at least either the supply flow rate or the exhaust flow rate temporarily changes to zero in replacing the treating gas with the inert gas. Therefore, it is easy to time-dependently change at least either the supply flow rate or the exhaust flow rate in the replacing step. This makes it easy to time-dependently change the intensity of the flow of the gaseous body in the treatment space in the replacing step. Therefore, it is easy to appropriately replace the treating gas in the treatment space with the inert gas in the replacing step.

It is preferred in the substrate processing method that the inert gas is intermittently supplied to the treatment space in the replacing step. In other words, it is preferred in the substrate processing method that the inert gas is intermittently supplied to the treatment space in replacing the treating gas with the inert gas. Therefore, it is easy to time-dependently change the supply flow rate in the replacing step. This makes it easy to time-dependently change the intensity of the flow of the gaseous body in the treatment space in the replacing step. Therefore, it is easy to appropriately replace the treating gas in the treatment space with the inert gas in the replacing step.

It is preferred in the substrate processing method that the gaseous body in the treatment space is intermittently exhausted in the replacing step. In other words, it is preferred in the substrate processing method that the gaseous body in the treatment space is intermittently exhausted in replacing the treating gas with the inert gas. Therefore, it is easy to time-dependently change the exhaust flow rate in the replacing step. This makes it easy to time-dependently change the intensity of the flow of the gaseous body in the treatment space in the replacing step. Therefore, it is easy to appropriately replace the treating gas in the treatment space with the inert gas in the replacing step.

It is preferred in the substrate processing method that the inert gas is supplied to the treatment space, and then both the supply flow rate and the exhaust flow rate simultaneously change to zero in the replacing step. In other words, it is preferred in the substrate processing method that the inert gas is supplied to the treatment space, and then both the supply flow rate and the exhaust flow rate simultaneously change to zero in replacing the treating gas with the inert gas. In the replacing step, the inert gas is supplied to the treatment space, and then the supply flow rate changes to zero. Therefore, it is easy to time-dependently change the supply flow rate in the replacing step. This makes it easy to time-dependently change the intensity of the flow of the gaseous body in the treatment space in the replacing step. Therefore, it is easy to appropriately replace the treating gas in the treatment space with the inert gas in the replacing step.

When the inert gas is supplied to the treatment space, the gaseous body flows in the treatment space. When both the supply flow rate and the exhaust flow rate are simultaneously zero, no gaseous body flows in the treatment space. In the replacing step, the inert gas is supplied to the treatment space, and then both the supply flow rate and the exhaust flow rate simultaneously change to zero. Therefore, it is easy to generate the flow of the gaseous body in the treatment space. It is easy to stop the flow of the gaseous body in the treatment space after generating the flow of the gaseous body in the treatment space. Here, stopping the flow of the gaseous body in the treatment space further promotes the diffusion of the treating gas in the treatment space. This makes it easier for the treating gas to diffuse throughout the treatment space in the replacing step. Therefore, it is easier to make the local concentrations of the treating gas uniform throughout the treatment space in the replacing step. It is easier to reduce the difference between the local concentrations of the treating gas in the replacing step. As a result, it is easier to appropriately replace the treating gas in the treatment space with the inert gas in the replacing step.

It is preferred in the substrate processing method that the replacing step includes a strong step and a weak step, the strong step and the weak step are alternately executed, and at least either the supply flow rate or the exhaust flow rate is different between the strong step and the weak step. In other words, it is preferred in the substrate processing method that replacing the treating gas with the inert gas includes a strong step and a weak step, the strong step and the weak step are alternately executed, and at least either the supply flow rate or the exhaust flow rate is different between the strong step and the weak step. Therefore, when the strong step and the weak step are alternately executed, at least either the supply flow rate or the exhaust flow rate changes. Therefore, it is easy to time-dependently change at least either the supply flow rate or the exhaust flow rate in the replacing step. This makes it easy to time-dependently change the intensity of the flow of the gaseous body in the treatment space in the replacing step. Therefore, it is easy to appropriately replace the treating gas in the treatment space with the inert gas in the replacing step.

It is preferred in the substrate processing method that the supply flow rate of the weak step is equal to or less than the supply flow rate of the strong step, and the exhaust flow rate of the weak step is equal to or less than the exhaust flow rate of the strong step. Therefore, it is easy to make at least either the supply flow rate or the exhaust flow rate different between the strong step and the weak step. Furthermore, it is easy to weaken or stop the flow of the gaseous body in the treatment space in the weak step. It is easy to generate or strengthen the flow of the gaseous body in the treatment space in the strong step.

It is preferred in the substrate processing method that at least either the supply flow rate or the exhaust flow rate is zero in the weak step. When the supply flow rate of the weak step is zero, it is easy to make the supply flow rate of the weak step equal to or less than the supply flow rate of the strong step. When the exhaust flow rate of the weak step is zero, it is easy to make the exhaust flow rate of the weak step equal to or less than the exhaust flow rate of the strong step. Furthermore, it is easy to weaken or stop the flow of the gaseous body in the treatment space in the weak step.

It is preferred in the substrate processing method that the supply flow rate is zero and the exhaust flow rate is zero in the weak step. Therefore, it is easier to make the supply flow rate of the weak step equal to or less than the supply flow rate of the strong step. It is easier to make the exhaust flow rate of the weak step equal to or less than the exhaust flow rate of the strong step. Furthermore, it is easier to stop the flow of the gaseous body in the treatment space in the weak step. This makes it easier for the treating gas to diffuse throughout the treatment space in the weak step. Therefore, it is easier to make the local concentrations of the treating gas uniform throughout the treatment space in the weak step. It is easier to reduce the difference between the local concentrations of the treating gas in the weak step. As a result, it is easier to appropriately replace the treating gas in the treatment space with the inert gas in the replacing step.

It is preferred in the substrate processing method that a time length of the single weak step is equal to or shorter than a time length of the single strong step. Therefore, it is easy to shorten the time length of the weak step. This makes it easy to shorten the time length of the replacing step. Furthermore, it is easy to lengthen the time length of the strong step. This makes it easy to appropriately replace the treating gas in the treatment space with the inert gas in the replacing step. In summary, it is easy to efficiently replace the treating gas in the treatment space with the inert gas in the replacing step.

It is preferred in the substrate processing method that a time length of the single weak step is equal to or shorter than half a time length of the single strong step. Therefore, it is easier to shorten the time length of the weak step. This makes it easier to shorten the time length of the replacing step. Furthermore, it is easier to lengthen the time length of the strong step. This makes it easier to appropriately replace the treating gas in the treatment space with the inert gas in the replacing step. In summary, it is easier to efficiently replace the treating gas in the treatment space with the inert gas in the replacing step.

It is preferred in the substrate processing method that a number of the strong steps included in the replacing step is two or more, and a number of the weak steps included in the replacing step is one or more. Therefore, it is easy to alternately execute the strong step and the weak step.

It is preferred in the substrate processing method that a number of the strong steps included in the replacing step is four or more, and a number of the weak steps included in the replacing step is three or more. Therefore, it is easy to alternately and repeatedly execute the strong step and the weak step. This makes it easy to increase the number of times of temporally changing at least either the supply flow rate or the exhaust flow rate in the replacing step. In other words, this makes it easy to increase the number of times of time-dependently changing at least either the supply flow rate or the exhaust flow rate in the replacing step. Thus, it is easy to increase the number of times of temporally changing the intensity of the flow of the gaseous body in the treatment space in the replacing step. In other words, it is easy to increase the number of times of time-dependently changing the intensity of the flow of the gaseous body in the treatment space in the replacing step. Therefore, it is easier to appropriately replace the treating gas in the treatment space with the inert gas in the replacing step.

It is preferred in the substrate processing method that an amount of the inert gas supplied to the treatment space is defined as a supply amount, an amount of the gaseous body exhausted from the treatment space is defined as an exhaust amount, and a difference between the supply amount and the exhaust amount in the single weak step is different from a difference between the supply amount and the exhaust amount in the single strong step. Here, the difference between the supply amount and the exhaust amount affects the pressure in the treatment space. Therefore, it is easy to make the pressure in the treatment space in the weak step different from the pressure in the treatment space in the strong step. This makes it easy to temporally change the pressure in the treatment space in the replacing step. Here, the temporal change of the pressure in the treatment space promotes the diffusion of the treating gas. This makes it easier for the treating gas to diffuse throughout the treatment space in the replacing step. Therefore, it is easier to make the local concentrations of the treating gas uniform throughout the treatment space in the replacing step. It is easier to reduce the difference between the local concentrations of the treating gas in the replacing step. As a result, it is easier to appropriately replace the treating gas in the treatment space with the inert gas in the replacing step.

It is preferred in the substrate processing method that the strong step performed first among a plurality of the strong steps is defined as a first strong step, the weak step performed immediately after the first strong step is defined as a first weak step, and a flow of the gaseous body in the treatment space in the first weak step is weaker than a flow of the gaseous body in the treatment space in the first strong step. The first strong step is one of the strong steps. The first strong step is performed first among the plurality of strong steps. The first weak step is one of the weak steps. The first weak step is performed immediately after the first strong step. The flow of the gaseous body in the treatment space in the first weak step is weaker than the flow of the gaseous body in the treatment space in the first strong step. Therefore, the intensity of the flow of the gaseous body in the treatment space changes between the first strong step and the first weak step. This makes it easy to time-dependently change the intensity of the flow of the gaseous body in the treatment space in the replacing step. Therefore, it is easy to appropriately replace the treating gas in the treatment space with the inert gas in the replacing step.

It is preferred in the substrate processing method that the strong step performed immediately after the first weak step is defined as a second strong step, and a flow of the gaseous body in the treatment space in the second strong step is stronger than the flow of the gaseous body in the treatment space in the first weak step. The second strong step is one of the strong steps. The second strong step is performed immediately after the first weak step. The flow of the gaseous body in the treatment space in the second strong step is stronger than the flow of the gaseous body in the treatment space in the first weak step. Therefore, the intensity of the flow of the gaseous body in the treatment space changes between the first weak step and the second strong step. This makes it easy to time-dependently change the intensity of the flow of the gaseous body in the treatment space in the replacing step. Therefore, it is easy to appropriately replace the treating gas in the treatment space with the inert gas in the replacing step.

It is preferred in the substrate processing method that the strong step performed last among the plurality of strong steps is defined as a final strong step, and a time length of the final strong step is longer than a time length of the first strong step. The final strong step is one of the strong steps. The final strong step is performed last among the plurality of strong steps. The time length of the final strong step is longer than the time length of the first strong step. Therefore, it is easy to sufficiently exhaust the treating gas from the treatment space in the final strong step. Therefore, it is easy to appropriately replace the treating gas in the treatment space with the inert gas in the replacing step.

It is preferred in the substrate processing method that the pressure in the treatment space in the final strong step is higher than the pressure in the treatment space in the first strong step. Therefore, it is easy to reduce a difference between the pressure in the treatment space in the final strong step and the atmospheric pressure. This makes it easy to reduce the difference between the pressure in the treatment space and the atmospheric pressure when the replacing step is switched to the pressure restoration step. Therefore, it is easy to restore the pressure in the treatment space to the atmospheric pressure in the pressure restoration step.

The present invention provides a substrate processing apparatus including: a treatment container configured to accommodate a substrate; a treating gas supply unit connected to the treatment container and configured to supply a treating gas to the treatment container; an inert gas supply unit connected to the treatment container and configured to supply an inert gas to the treatment container; an exhaust unit connected to the treatment container and configured to exhaust a gaseous body from the treatment container; and a controller configured to control the treating gas supply unit, the inert gas supply unit, and the exhaust unit to execute a treating operation for treating the substrate in the treatment container and a replacing operation for replacing the treating gas in the treatment container with the inert gas, wherein in the treating operation, the treating gas supply unit supplies the treating gas to the treatment container, in the replacing operation, the inert gas supply unit supplies the inert gas to the treatment container, and the exhaust unit exhausts the gaseous body from the treatment container, and in the replacing operation, the controller controls the inert gas supply unit and the exhaust unit to time-dependently change an intensity of a flow of the gaseous body in the treatment container.

The substrate processing apparatus includes the treatment container, the treating gas supply unit, the inert gas supply unit, the exhaust unit, and the controller. The treatment container is configured to accommodate the substrate. The treating gas supply unit is connected to the treatment container. The treating gas supply unit is configured to supply the treating gas to the treatment container. The inert gas supply unit is connected to the treatment container. The inert gas supply unit is configured to supply the inert gas to the treatment container. The exhaust unit is connected to the treatment container. The exhaust unit is configured to exhaust the gaseous body from the treatment container. The Gaseous body is rephrased as a gas. The controller controls the treating gas supply unit, the inert gas supply unit, and the exhaust unit. The controller executes the treating operation and the replacing operation. The treating operation is for treating the substrate in the treatment container. The replacing operation is for replacing the treating gas in the treatment container with the inert gas. In the treating operation, the treating gas supply unit supplies the treating gas to the treatment container. In the treating operation, the substrate in the treatment container is treated with the treating gas. In the replacing operation, the inert gas supply unit supplies the inert gas to the treatment container, and the exhaust unit exhausts the gaseous body from the treatment container.

In the replacing operation, the controller controls the inert gas supply unit and the exhaust unit to time-dependently change the intensity of the flow of the gaseous body in the treatment container. In other words, in the replacing operation, the controller controls the inert gas supply unit and the exhaust unit to change the intensity of the flow of the gaseous body with time in the treatment container. In other words, in the replacing operation, the controller controls the inert gas supply unit and the exhaust unit to temporally change the intensity of the flow of the gaseous body in the treatment container. In other words, in the replacing operation, the controller controls the inert gas supply unit and the exhaust unit to change the intensity of the flow of the gaseous body in the treatment container as time passes. Here, the temporal change of the intensity of the flow of the gaseous body in the treatment container promotes diffusion of the treating gas in the treatment container. The temporal change is rephrased as the change over time. The temporal change is rephrased as the time-dependent change. This makes it easy for the treating gas to diffuse throughout the treatment container in the replacing operation. It is difficult for the treating gas to stay in the local area within the treatment container in the replacing operation. Therefore, it is easy to make the local concentrations of the treating gas uniform throughout the treatment container in the replacing operation. It is easy to reduce the difference between the local concentrations of the treating gas in the replacing operation. As a result, it is easy to appropriately replace the treating gas in the treatment container with the inert gas in the replacing operation. It is easy to sufficiently exhaust the treating gas from the treatment container in the replacing operation.

In summary, the substrate processing apparatus appropriately replaces the treating gas with the inert gas.

It is preferred in the substrate processing apparatus that the controller controls the inert gas supply unit and the exhaust unit to intermittently stop the flow of the gaseous body in the treatment container in the replacing operation. This makes it easy for the controller to time-dependently change the intensity of the flow of the gaseous body in the treatment container in the replacing operation. Therefore, it is easy to appropriately replace the treating gas in the treatment container with the inert gas in the replacing operation.

Furthermore, when the flow of the gaseous body in the treatment container stops, it is easier for the treating gas to diffuse throughout the treatment container. Therefore, it is easier to make the local concentrations of the treating gas uniform throughout the treatment container in the replacing operation. It is easier to reduce the difference between the local concentrations of the treating gas in the replacing operation. As a result, it is easier to appropriately replace the treating gas in the treatment container with the inert gas in the replacing operation.

### BRIEF DESCRIPTION OF THE DRAWINGS

For the purpose of illustrating the invention, there are shown in the drawings several forms which are presently preferred, it being understood, however, that the invention is not limited to the precise arrangement and instrumentalities shown.
FIG. 1 is a cross-sectional view of a substrate processing apparatus according to an embodiment;
FIG. 2 is a cross-sectional view of the substrate processing apparatus according to the embodiment;
FIG. 3 is a plan view illustrating the inside of a treatment container;
FIG. 4 is a control block diagram of the substrate processing apparatus;
FIG. 5 is a flowchart illustrating a procedure of a first substrate processing method;
FIG. 6 is a timing chart of the first substrate processing method;
FIG. 7 is a drawing for explaining a treatment space in a first strong step;
FIG. 8 is a drawing for explaining the treatment space in a first weak step;
FIG. 9 is a drawing for explaining the treatment space in the first weak step;
FIG. 10 is a drawing for explaining the treatment space in a second strong step;
FIG. 11 is a drawing illustrating parameters of a replacing step;
FIG. 12 is a flowchart illustrating a procedure of a second substrate processing method;
FIG. 13 is a timing chart of the second substrate processing method;
FIG. 14 is a table illustrating Examples 1 to 3; and
FIG. 15 is a timing chart of a supply flow rate and an exhaust flow rate according to a modification.

### DETAILED DESCRIPTION

Hereinafter, a substrate processing method and a substrate processing apparatus according to the present invention will be described with reference to the drawings.

### <1. Outline of substrate processing apparatus 1>

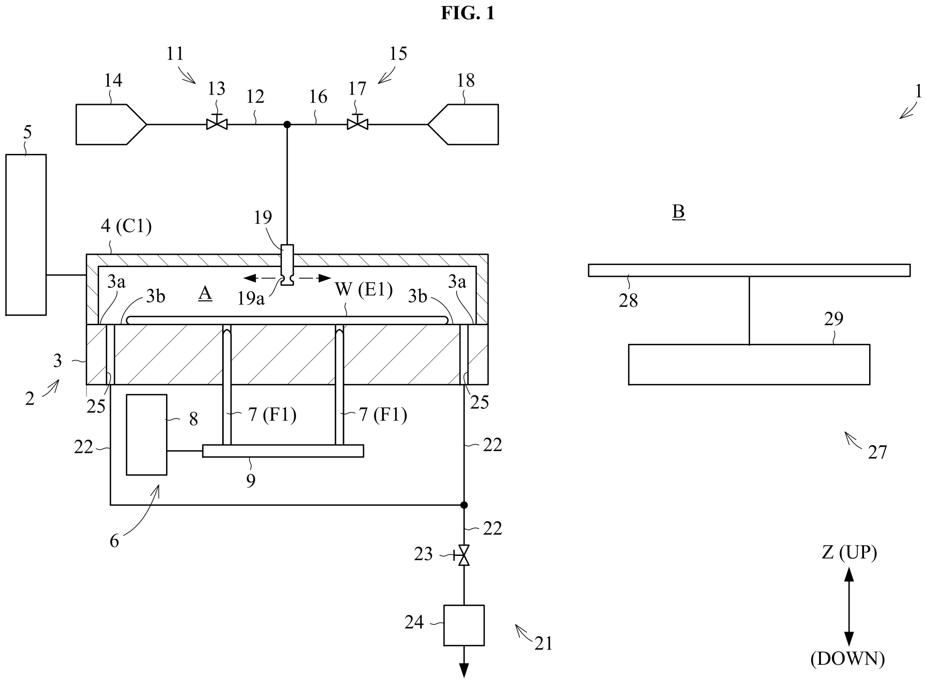

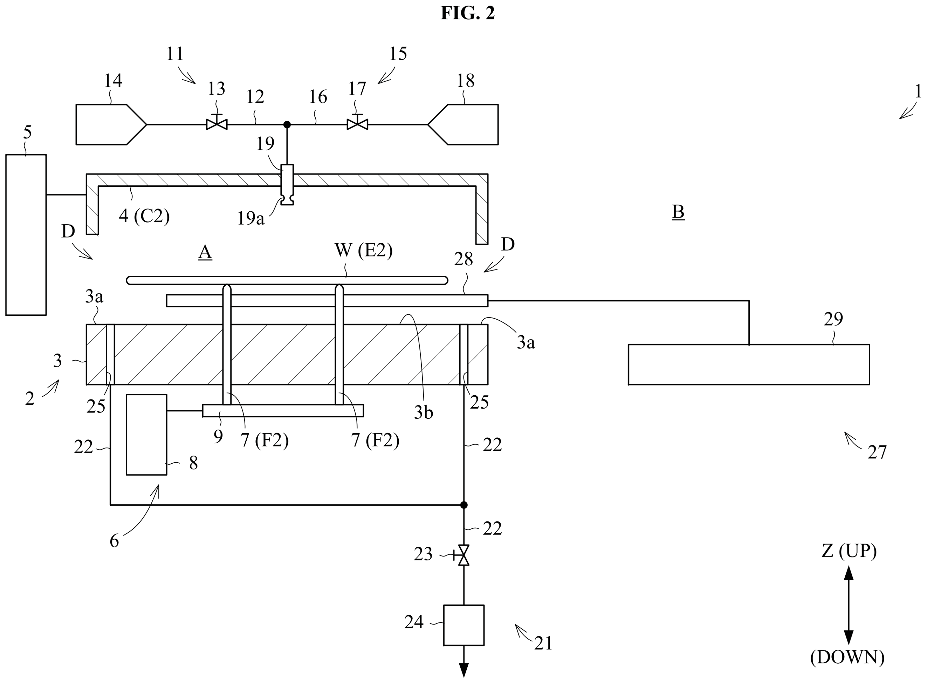

FIGS. 1 and 2 are cross-sectional views of a substrate processing apparatus 1 according to an embodiment. The substrate processing apparatus 1 processes a substrate W.

The substrate W is, for example, any of a semiconductor wafer, a liquid crystal display substrate, an organic electroluminescence (OEL) substrate, a flat panel display (FPD) substrate, an optical display substrate, a magnetic disk substrate, an optical disk substrate, a magneto-optical disk substrate, a photomask substrate, and a solar cell substrate.

The substrate W has a thin flat plate shape. The substrate W has a substantially circular shape in plan view.

The substrate processing apparatus 1 treats the substrate W with a treating gas. Treatment performed on the substrate W by the substrate processing apparatus 1 is, for example, an adhesion enhancement treatment. The adhesion enhancement treatment is, for example, for changing the wettability of the substrate W. In a case where a coating film is formed on the substrate W after the adhesion enhancement treatment, the coating film has high adhesion to the substrate W. The coating film is, for example, a resist film.

The substrate processing apparatus 1 includes a treatment container 2. The treatment container 2 is configured to accommodate the substrate W.

The treatment container 2 defines a treatment space A. The treatment space A is located in the treatment container 2. The treatment space A accommodates the substrate W.

The treatment container 2 includes a plate 3 and a lid 4. The lid 4 is disposed above the plate 3. The plate 3 has, for example, a horizontal plate shape. The lid 4 has, for example, a bowl shape.

The treatment space A is located between the plate 3 and the lid 4. For example, the plate 3 defines a lower part of the treatment space A. The lid 4 defines an upper part of the treatment space A.

The substrate processing apparatus 1 includes a lid driver 5. The lid driver 5 moves the lid 4 with respect to the plate 3. The lid driver 5 includes, for example, an air cylinder.

The lid driver 5 moves the lid 4 to a closed position C1. FIG. 1 illustrates the lid 4 located at the closed position C1. When the lid 4 is located at the closed position C1, the lid 4 is in contact with the plate 3.

The plate 3 includes a circumferential portion 3a. Although not illustrated, the circumferential portion 3a has an annular shape in plan view. When the lid 4 is located at the closed position C1, the lid 4 is in contact with the circumferential portion 3a.

When the lid 4 is located at the closed position C1, the treatment space A is closed. For convenience, a space located outside the treatment container 2 is referred to as an external space B. When the lid 4 is located at the closed position C1, the treatment space A is isolated from the external space B. When the lid 4 is located at the closed position C1, it is easy to make a pressure in the treatment space A lower than atmospheric pressure.

The lid driver 5 moves the lid 4 to an open position C2. FIG. 2 illustrates the lid 4 located at the open position C2. The open position C2 is located at a position higher than the closed position C1. When the lid 4 is located at the open position C2, the lid 4 is separated from the plate 3. When the lid 4 is located at the open position C2, the lid 4 is separated from the circumferential portion 3a.

When the lid 4 is located at the open position C2, a gap D is formed. The gap D is located between the plate 3 and the lid 4. The gap D is located between the circumferential portion 3a and the lid 4.

When the lid 4 is located at the open position C2, the treatment space A is opened. When the lid 4 is located at the open position C2, the treatment space A is opened through the gap D. When the lid 4 is located at the open position C2, the treatment space A communicates with the external space B through the gap D.

The plate 3 supports the substrate W. The plate 3 supports the substrate W in a horizontal attitude. The plate 3 supports one substrate W at a time.

The plate 3 includes a support portion 3b. The support portion 3b supports the substrate W. The substrate W is placed on the support portion 3b.

The support portion 3b is substantially horizontal. The support portion 3b is substantially flat. The support portion 3b is located within the circumferential portion 3a. The support portion 3b has a circular shape in plan view. Although not illustrated, the support portion 3b is larger than the substrate W in plan view.

The substrate processing apparatus 1 may include a proximity ball (not illustrated). The proximity ball is disposed in the support portion 3b. The proximity ball slightly protrudes upward from the support portion 3b. When the substrate W is supported by the plate 3, the proximity ball comes into contact with a back surface of the substrate W to form a minute gap between the back surface of the substrate W and the support portion 3b.

The position of the substrate W supported by the plate 3 is referred to as a treatment position E1. The "substrate W supported by the plate 3" is rephrased as the "substrate W located at the treatment position E1". FIG. 1 illustrates the substrate W located at the treatment position E1. The treatment position E1 is located in the treatment space A.

The treatment container 2 is rephrased as a treatment chamber 2. The plate 3 is rephrased as a container body 3, a chamber body 3, or a substrate support portion 3.

The substrate processing apparatus 1 may include a temperature adjuster (not illustrated). The temperature adjuster adjusts the temperature of the substrate W on the plate 3. For example, the temperature adjuster heats the temperature of the substrate W on the plate 3 to a temperature higher than a room temperature. The temperature adjuster is attached to the plate 3. The temperature adjuster is disposed inside the plate 3. The temperature adjuster includes a heater.

The substrate processing apparatus 1 includes a substrate lifting mechanism 6. The substrate lifting mechanism 6 moves up and down the substrate W between the treatment position E1 and a transport position E2. FIG. 2 illustrates the substrate W located at the transport position E2. The transport position E2 is located in the treatment space A. The transport position E2 is located at a position higher than the treatment position E1. When the substrate W is located at the transport position E2, the substrate W is not supported by the plate 3.

The substrate lifting mechanism 6 includes a plurality of pins 7. Each of the pins 7 extends in a vertical direction Z. The pins 7 individually pass through the plate 3.

The substrate lifting mechanism 6 includes a power source 8. The power source 8 moves up and down the pins 7 with respect to the plate 3. The power source 8 includes, for example, an air cylinder.

The substrate lifting mechanism 6 includes, for example, one support piece 9. The support piece 9 is connected to the plurality of pins 7. The power source 8 moves up and down the support piece 9 with respect to the plate 3. As a result, the power source 8 collectively moves up and down the plurality of pins 7.

The power source 8 moves the pins 7 to a standby position F1. FIG. 1 illustrates the pins 7 located at the standby position F1. When the pins 7 are located at the standby position F1, the pins 7 do not protrude upward from the plate 3. When the pins 7 are located at the standby position F1, the pins 7 are not in contact with the substrate W. When the pins 7 are located at the standby position F1, the pins 7 are not in contact with the substrate W at the treatment position E1, for example.

The power source 8 moves the pins 7 to a support position F2. FIG. 2 illustrates the pins 7 located at the support position F2. When the pins 7 are located at the support position F2, the pins 7 protrude upward from the plate 3. When the pins 7 are located at the support position F2, the pins 7 support the substrate W. When the pins 7 are located at the support position F2, the pins 7 support the substrate W in a horizontal attitude.

The transport position E2 is the position of the substrate W supported by the pins 7 at the support position F2. When the pins 7 move between the standby position F1 and the support position F2, the substrate W moves between the treatment position E1 and the transport position E2.

The substrate processing apparatus 1 includes a treating gas supply unit 11. The treating gas supply unit 11 is connected to the treatment container 2. For example, the treating gas supply unit 11 is connected to the lid 4. The treating gas supply unit 11 is configured to supply a treating gas to the treatment container 2.

The treating gas is also referred to as an adhesion enhancing gas. The treating gas contains an adhesion enhancer. The adhesion enhancer contains, for example, a silylating agent. The silylating agent contains, for example, at least one of hexamethyldisilazane (HMDS), trimethylsilyldimethylamine (TMSDMA), or trimethylsilyldiethylamine (TMSDEA). The treating gas may further contain a carrier gas. The treating gas may be a mixture of the silylating agent and the carrier gas. The carrier gas contains, for example, nitrogen.

The treating gas supply unit 11 includes a pipe 12 and a valve 13. The pipe 12 is connected to the treatment container 2. For example, the pipe 12 is connected to the lid 4. The valve 13 is provided in the pipe 12. When the valve 13 is opened, the treating gas supply unit 11 supplies the treating gas to the treatment container 2. When the valve 13 is closed, the treating gas supply unit 11 does not supply the treating gas to the treatment container 2. The valve 13 includes at least either an on-off valve or a flow rate control valve.

The substrate processing apparatus 1 includes a treating gas supply source 14. The treating gas supply source 14 is connected to the treating gas supply unit 11. The treating gas supply source 14 is connected to the pipe 12. The treating gas supply source 14 supplies the treating gas to the treating gas supply unit 11.

For example, the treating gas supply source 14 may generate the treating gas. The treating gas supply source 14 includes at least one of a vaporizer, a tank, or a heater.

The substrate processing apparatus 1 includes an inert gas supply unit 15. The inert gas supply unit 15 is connected to the treatment container 2. For example, the inert gas supply unit 15 is connected to the lid 4. The inert gas supply unit 15 is configured to supply an inert gas to the treatment container 2.

The inert gas contains at least one of nitrogen, argon, or helium.

The inert gas supply unit 15 includes a pipe 16 and a valve 17. The pipe 16 is connected to the treatment container 2. For example, the pipe 16 is connected to the lid 4. The valve 17 is provided in the pipe 16. When the valve 17 is opened, the inert gas supply unit 15 supplies the inert gas to the treatment container 2. When the valve 17 is closed, the inert gas supply unit 15 does not supply the inert gas to the treatment container 2. The valve 17 includes at least either an on-off valve or a flow rate control valve.

The valve 17 may adjust a flow rate of the inert gas supplied to the treatment container 2. The flow rate of the inert gas supplied to the treatment container 2 is synonymous with the flow rate of the inert gas supplied to the treatment space A.

Here, the flow rate of the inert gas supplied to the treatment space A is referred to as a supply flow rate G.

The substrate processing apparatus 1 includes an inert gas supply source 18. The inert gas supply source 18 is connected to the inert gas supply unit 15. The inert gas supply source 18 is connected to the pipe 16. The inert gas supply source 18 supplies the inert gas to the inert gas supply unit 15.

The substrate processing apparatus 1 includes a nozzle 19. The nozzle 19 is attached to the treatment container 2. For example, the nozzle 19 is attached to the lid 4. The nozzle 19 is disposed at the center of the lid 4.

The nozzle 19 is inserted into the treatment space A. The nozzle 19 is disposed above the substrate W in the treatment container 2. The nozzle 19 is disposed above the center of the substrate W in the treatment container 2.

The nozzle 19 is connected to the treating gas supply unit 11. The nozzle 19 is connected to the pipe 12. The nozzle 19 ejects the treating gas into the treatment container 2.

The treating gas supply unit 11 supplies the treating gas to the treatment container 2 through the nozzle 19.

The nozzle 19 is connected to the inert gas supply unit 15. The nozzle 19 is connected to the pipe 16. The nozzle 19 ejects the inert gas into the treatment container 2.

The inert gas supply unit 15 supplies the inert gas to the treatment container 2 through the nozzle 19.

For example, the nozzle 19 ejects the treating gas and the inert gas in a substantially horizontal direction.

The nozzle 19 has an ejection port 19a. The ejection port 19a is disposed in the treatment container 2. The nozzle 19 ejects the treating gas and the inert gas from the ejection port 19a.

The substrate processing apparatus 1 includes an exhaust unit 21. The exhaust unit 21 is connected to the treatment container 2. For example, the exhaust unit 21 is connected to the plate 3. The exhaust unit 21 is configured to exhaust a gaseous body from the treatment container 2. The Gaseous body is rephrased as a gas.

The exhaust unit 21 includes a pipe 22, a valve 23, and a pressure reducer 24. The pipe 22 is connected to the treatment container 2. For example, the pipe 22 is connected to the plate 3. The valve 23 is provided in the pipe 22. The pressure reducer 24 is provided in the pipe 22. When the valve 23 is opened and the pressure reducer 24 is operated, the exhaust unit 21 exhausts the gaseous body from the treatment container 2. When the valve 23 is closed, the exhaust unit 21 does not exhaust the gaseous body from the treatment container 2. When the pressure reducer 24 is stopped, the exhaust unit 21 does not exhaust the gaseous body from the treatment container 2. The valve 23 includes at least either an on-off valve or a flow rate control valve. The pressure reducer 24 includes a vacuum pump.

The valve 23 may adjust a flow rate of the gaseous body exhausted from the treatment container 2. The flow rate of the gaseous body exhausted from the treatment container 2 is synonymous with the flow rate of the gaseous body exhausted from the treatment space A.

Here, the flow rate of the gaseous body exhausted from the treatment space A is referred to as an exhaust flow rate H.

The substrate processing apparatus 1 includes an exhaust port 25. The exhaust port 25 is provided in the treatment container 2. The exhaust port 25 communicates with, for example, the treatment space A. The exhaust port 25 is provided in the plate 3, for example. The exhaust port 25 passes through the plate 3, for example.

The exhaust unit 21 is connected to the exhaust port 25. The pipe 22 is connected to the exhaust port 25. The exhaust unit 21 communicates with the treatment space A through the exhaust port 25. The exhaust unit 21 exhausts the gaseous body from the treatment space A through the exhaust port 25.

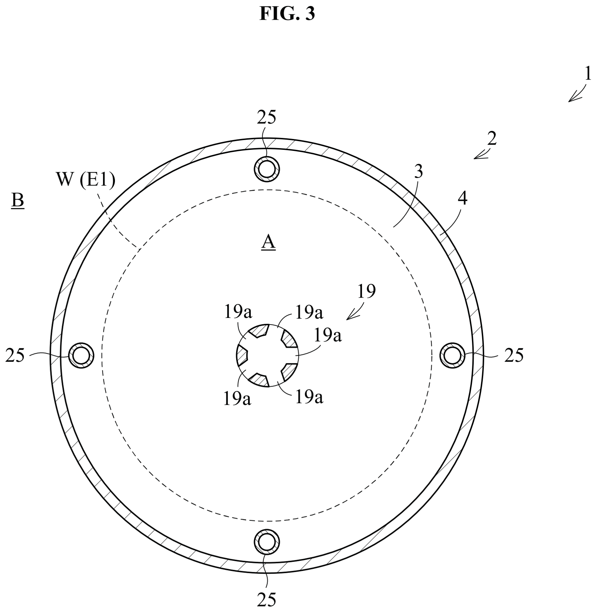

FIG. 3 is a plan view illustrating the inside of the treatment container 2. In FIG. 3, the substrate W located at the treatment position E1 is indicated by a broken line. FIG. 3 illustrates a cross section of a part of the lid 4.

The nozzle 19 overlaps the substrate W at the treatment position E1 in plan view. The nozzle 19 overlaps the center of the substrate W at the treatment position E1 in plan view.

The number of ejection ports 19a included in one nozzle 19 is, for example, five. Each of the ejection ports 19a has, for example, a circular shape. The plurality of ejection ports 19a are disposed in a circumferential direction of a vertical axis passing through the nozzle 19. The treating gas and the inert gas are sprayed radially from the nozzle 19 in plan view.

The exhaust port 25 does not overlap the substrate W at the treatment position E1 in plan view. The exhaust port 25 is disposed outside the substrate W at the treatment position E1 in plan view.

The number of exhaust ports 25 provided in one treatment container 2 is, for example, four. Each of the exhaust ports 25 has, for example, a circular shape. The plurality of exhaust ports 25 are disposed along the circumferential portion of the plate 3.

Reference is made to FIGS. 1 and 2. The substrate processing apparatus 1 includes a substrate transporting mechanism 27. The substrate transporting mechanism 27 is disposed in the external space B. The substrate transporting mechanism 27 transports the substrate W. The substrate transporting mechanism 27 transports the substrate W between the treatment space A and the external space B. The substrate transporting mechanism 27 transports the substrate W between the treatment space A and the external space B through the gap D. The substrate transporting mechanism 27 places the substrate W on the pins 7 and takes the substrate W from the pins 7. The substrate transporting mechanism 27 is, for example, a transport robot.

The substrate transporting mechanism 27 includes a hand 28. The hand 28 supports the substrate W in a horizontal attitude. When the lid 4 is located at the open position C2, the hand 28 can pass through the gap D.

The substrate transporting mechanism 27 includes a hand driver 29. The hand driver 29 is connected to the hand 28. The hand driver 29 moves the hand 28. The hand driver 29 moves the hand 28 in the horizontal direction and the vertical direction Z, for example. The hand driver 29 rotates the hand 28 in a horizontal plane, for example.

For example, the hand driver 29 includes a power source (not illustrated). The power source is, for example, an electric motor. For example, the hand driver 29 includes a power transmission mechanism (not illustrated). The power transmission mechanism includes at least either a feed screw mechanism or a belt mechanism.

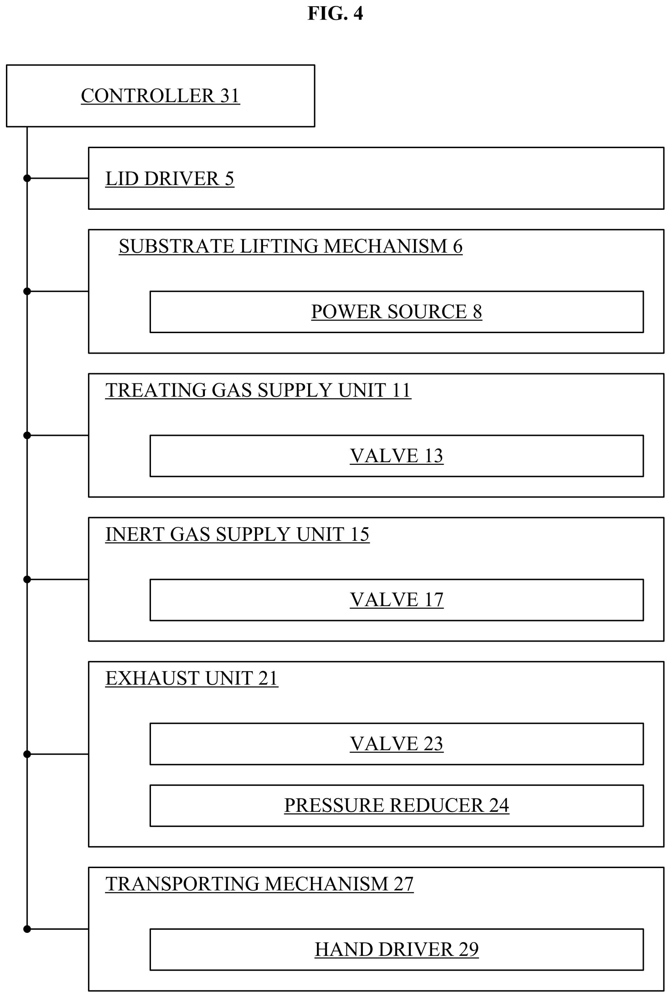

FIG. 4 is a control block diagram of the substrate processing apparatus 1. The substrate processing apparatus 1 includes a controller 31. The controller 31 controls the lid driver 5. The controller 31 controls the substrate lifting mechanism 6. The controller 31 controls the power source 8. The controller 31 controls the treating gas supply unit 11. The controller 31 controls the valve 13. The controller 31 controls the inert gas supply unit 15. The controller 31 controls the valve 17. The controller 31 controls the exhaust unit 21. The controller 31 controls the valve 23 and the pressure reducer 24. The controller 31 controls the substrate transporting mechanism 27. The controller 31 controls the hand driver 29.

The controller 31 is constructed by, for example, a central processing unit (CPU), a random access memory (RAM), and a storage medium. The central processing unit executes arithmetic processing. The random access memory functions as a work area for arithmetic processing. The storage medium is, for example, a hard disk. The controller 31 has various types of information. The various types of information are stored in advance in the storage medium. The information included in the controller 31 includes, for example, substrate transport information and treatment information. The substrate transport information defines a transport procedure of the substrate W. The treatment information defines a treatment procedure of the substrate W. The treatment information is also referred to as a treatment recipe.

### <2. Substrate processing method>

The substrate processing method is executed by the substrate processing apparatus 1. The substrate processing method is for processing the substrate W.

Hereinafter, a first substrate processing method and a second substrate processing method will be described.

### <2-1. First substrate processing method>

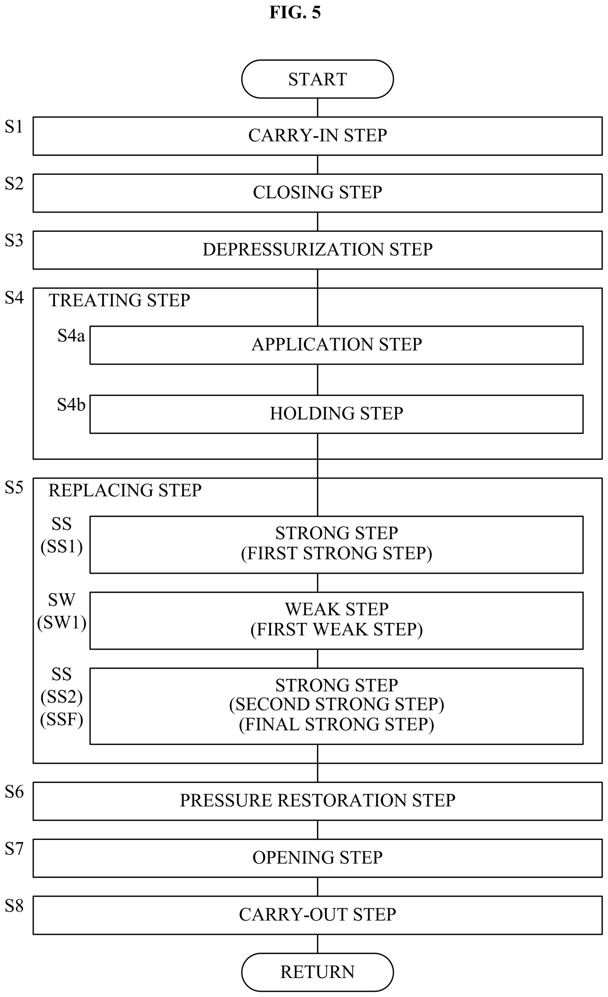

FIG. 5 is a flowchart illustrating a procedure of the first substrate processing method. The first substrate processing method includes steps S1 to S8. Steps S1 to S8 are executed in this order. In steps S1 to S8, each element of the substrate processing apparatus 1 operates under the control of the controller 31.

### Carry-in step S1

The substrate W is carried into the treatment space A.

Specifically, the lid 4 is located at the open position C2. The treatment space A is opened to the external space B through the gap D. The pins 7 are located at the support position F2.

The substrate transporting mechanism 27 transports the substrate W from the external space B to the treatment space A through the gap D. Specifically, the hand 28 supports the substrate W. The hand driver 29 moves the hand 28. The hand 28 moves from the external space B to the treatment space A through the gap D together with the substrate W. The hand 28 places the substrate W on the pins 7. The hand 28 moves away from the substrate W. The hand 28 exits from the treatment space A to the external space B through the gap D without the substrate W.

The substrate W is supported by the pins 7. The substrate W is located at the transport position E2. The substrate W is accommodated in the treatment space A.

### Closing step S2

The treatment space A is closed.

First, the substrate lifting mechanism 6 moves the substrate W from the transport position E2 to the treatment position E1. Specifically, the pins 7 descend from the support position F2 to the standby position F1. The substrate W is located at the treatment position E1. The substrate W is supported by the plate 3. The pins 7 move away from the substrate W.

Next, the lid driver 5 moves the lid 4 from the open position C2 to the closed position C1. The gap D is closed. The treatment space A is closed. The treatment space A is isolated from the external space B.

### Depressurization step S3

The treatment space A is depressurized.

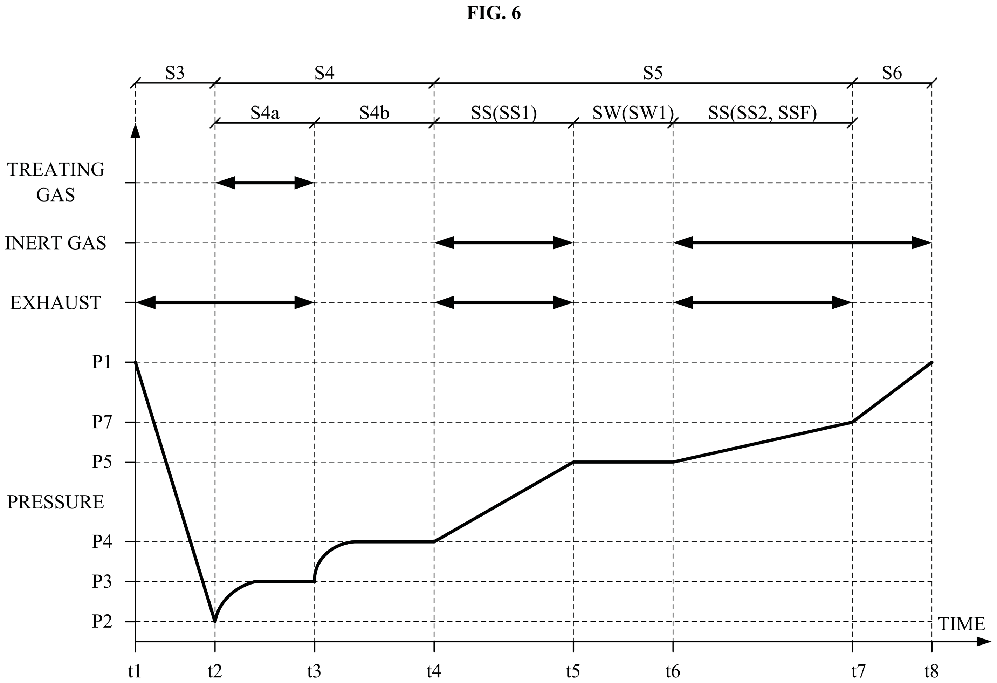

FIG. 6 is a timing chart of the first substrate processing method. FIG. 6 is a timing chart of the pressure in the treatment space A, the supply of the treating gas, the supply of the inert gas, and the exhaust. The depressurization step S3 is performed from a time t1 to a time t2.

In the depressurization step S3, the treatment space A is in a closed state. The treating gas supply unit 11 does not supply the treating gas to the treatment space A. The inert gas supply unit 15 does not supply the inert gas to the treatment space A. The exhaust unit 21 exhausts the gaseous body from the treatment space A.

The pressure in the treatment space A decreases from the atmospheric pressure. The pressure in the treatment space A decreases from a pressure P1 to a pressure P2. The pressure P1 is the pressure in the treatment space A at the time t1. The pressure P1 is equal to, for example, the atmospheric pressure. The pressure P1 is equal to, for example, a pressure in the external space B. The pressure P2 is the pressure in the treatment space A at the time t2. The pressure P2 is lower than the pressure P1. The pressure P2 is lower than the atmospheric pressure.

As used herein, the pressure is synonymous with the pressure of the gaseous body.

The pressure in the external space B is equal to, for example, the atmospheric pressure.

### Treating step S4

The substrate W is treated with the treating gas.

The treating step S4 is performed from the time t2 to a time t4.

In the treating step S4, the treatment space A is in a closed state. In the treating step S4, the pressure in the treatment space A is kept lower than the atmospheric pressure.

The controller 31 executes a treating operation for treating the substrate W in the treatment container 2. In the treating operation, the controller 31 controls the treating gas supply unit 11 to supply the treating gas to the treatment container 2. In the treating operation, the treating gas supply unit 11 supplies the treating gas to the treatment container 2. Furthermore, in the treating operation, the controller 31 may control the exhaust unit 21 to exhaust the gaseous body from the treatment container 2.

As a result, the treating gas is supplied to the treatment space A. The treating gas is supplied to the treatment space A in a state where the pressure in the treatment space A is kept lower than the atmospheric pressure. The treating gas is supplied to the substrate W in the treatment space A. The treating gas is applied to the substrate W. For example, the adhesion enhancer in the treating gas is applied to the substrate W.

The treating step S4 includes, for example, an application step S4a and a holding step S4b. The application step S4a and the holding step S4b are executed in this order.

### Application step S4a

The application step S4a is performed from the time t2 to a time t3.

In the application step S4a, the treating gas supply unit 11 supplies the treating gas to the treatment space A. The inert gas supply unit 15 does not supply the inert gas to the treatment space A. The exhaust unit 21 exhausts the gaseous body from the treatment space A.

As a result, the treating gas flows in the treatment space A. The treating gas flows from the nozzle 19 to the exhaust ports 25. The treatment space A is quickly filled with the treating gas.

The pressure in the treatment space A increases from the pressure P2 to a pressure P3. The pressure P3 is the pressure in the treatment space A at the time t3. The pressure P3 is lower than the atmospheric pressure. The pressure P3 is lower than the pressure P1. The pressure P3 is higher than the pressure P2.

### Holding step S4b

The holding step S4b is performed from the time t3 to the time t4.

In the holding step S4b, the treating gas supply unit 11 stops supplying the treating gas to the treatment space A. The inert gas supply unit 15 does not supply the inert gas to the treatment space A. The exhaust unit 21 stops exhausting the gaseous body from the treatment space A.

The flow of the treating gas in the treatment space A stops. In other words, the flow of the treating gas in the treatment space A disappears. The treatment space A is kept filled with the treating gas.

The pressure in the treatment space A increases from the pressure P3 to a pressure P4. The pressure P4 is the pressure in the treatment space A at the time t4. The pressure P4 is lower than the atmospheric pressure. The pressure P4 is lower than the pressure P1. The pressure P4 is higher than the pressure P3.

The pressure in the treatment space A in the holding step S4b is higher than the pressure in the treatment space A in the application step S4a.

### Replacing step S5

The treating gas is replaced with the inert gas.

The replacing step S5 is performed from the time t4 to a time t7. The replacing step S5 starts at the same time as the treating step S4 ends.

In the replacing step S5, the treatment space A is in a closed state. In the replacing step S5, the pressure in the treatment space A is kept lower than the atmospheric pressure.

The controller 31 executes a replacing operation for replacing the treating gas in the treatment container 2 with the inert gas. In the replacing operation, the controller 31 controls the inert gas supply unit 15 and the exhaust unit 21 to supply the inert gas to the treatment container 2 and exhaust the gaseous body from the treatment container 2. In the replacing operation, the inert gas supply unit 15 supplies the inert gas to the treatment container 2, and the exhaust unit 21 exhausts the gaseous body from the treatment container 2.

As a result, the inert gas is supplied to the treatment space A. The gaseous body in the treatment space A is exhausted. The gaseous body is exhausted from the treatment space A. In a state where the pressure in the treatment space A is kept lower than the atmospheric pressure, the inert gas is supplied to the treatment space A, and the gaseous body is exhausted from the treatment space A.

The treating gas in the treatment space A is replaced with the inert gas. The treating gas is exhausted from the treatment space A.

Here, in the replacing operation, the controller 31 controls the inert gas supply unit 15 and the exhaust unit 21 to time-dependently change the intensity of a flow of the gaseous body in the treatment container 2. For example, in the replacing operation, the controller 31 controls the inert gas supply unit 15 and the exhaust unit 21 to intermittently stop the flow of the gaseous body in the treatment container 2.

As a result, the intensity of the flow of the gaseous body in the treatment space A changes with time. For example, the intensity of the flow of the gaseous body in the treatment space A temporarily increases. The intensity of the flow of the gaseous body in the treatment space A temporarily decreases. The flow of the gaseous body in the treatment space A intermittently stops. The flow of the gaseous body in the treatment space A temporarily stops. The flow of the gaseous body in the treatment space A repeats generation and disappearance.

For example, the inert gas is intermittently supplied to the treatment space A. The inert gas is supplied to the treatment space A, and then the supply of the inert gas to the treatment space A is stopped. After the supply of the inert gas to the treatment space A is stopped, the inert gas is supplied to the treatment space A again.

The gaseous body in the treatment space A is intermittently exhausted. The gaseous body is intermittently exhausted from the treatment space A. The gaseous body is exhausted from the treatment space A, and then the exhaust of the gaseous body from the treatment space A is stopped. After the exhaust of the gaseous body from the treatment space A is stopped, the gaseous body is exhausted from the treatment space A again.

Specifically, in the replacing operation, the controller 31 controls the inert gas supply unit 15 and the exhaust unit 21 to time-dependently change at least either the supply flow rate G or the exhaust flow rate H. In other words, in the replacing operation, the controller 31 controls the inert gas supply unit 15 and the exhaust unit 21 to change at least either the supply flow rate G or the exhaust flow rate H with time. In other words, in the replacing operation, the controller 31 controls the inert gas supply unit 15 and the exhaust unit 21 to temporally change at least either the supply flow rate G or the exhaust flow rate H. In other words, in the replacing operation, the controller 31 controls the inert gas supply unit 15 and the exhaust unit 21 to change at least either the supply flow rate G or the exhaust flow rate H as time passes.

As a result, at least either the supply flow rate G or the exhaust flow rate H changes with time. In other words, at least either the supply flow rate G or the exhaust flow rate H changes temporally. In other words, at least either the supply flow rate G or the exhaust flow rate H changes time-dependently. In other words, at least either the supply flow rate G or the exhaust flow rate H changes as time passes.

For example, at least either the supply flow rate G or the exhaust flow rate H temporarily changes to zero. In other words, at least either the supply flow rate G or the exhaust flow rate H changes to zero for a portion of the time of the replacing step S5.

For example, the inert gas is supplied to the treatment space A, and then both the supply flow rate G and the exhaust flow rate H simultaneously change to zero.

The replacing step S5 includes, for example, a strong step SS and a weak step SW. The strong step SS and the weak step SW are alternately executed. The strong step SS and the weak step SW are executed successively in time.

In the strong step SS, the flow of the gaseous body is generated or becomes strong in the treatment space A. In the weak step SW, the flow of the gaseous body becomes weak or stops in the treatment space A. The flow of the gaseous body in the treatment space A in the weak step SW is weak. The flow of the gaseous body in the treatment space A in the weak step SW is weaker than the flow of the gaseous body in the treatment space A in the strong step SS. In the weak step SW, the flow of the gaseous body in the treatment space A disappears.

The intensity of the flow of the gaseous body in the treatment space A changes between the strong step SS and the weak step SW. The intensity of the flow of the gaseous body in the treatment space A changes between the strong step SS and the weak step SW performed successively in time.

The number of strong steps SS included in the replacing step S5 is two or more. The number of weak steps SW included in the replacing step S5 is one or more.

For example, the number of strong steps SS included in the replacing step S5 is four or more. The number of weak steps SW included in the replacing step S5 is three or more.

In the first substrate processing method, the number of strong steps SS included in the replacing step S5 is two. The number of weak steps SW included in the replacing step S5 is one.

The strong step SS performed first among the plurality of strong steps SS is defined as a first strong step SS1. The weak step SW performed immediately after the first strong step SS1 is defined as a first weak step SW1. The strong step SS performed immediately after the first weak step SW1 is defined as a second strong step SS2.

The strong step SS performed last among the plurality of strong steps SS is defined as a final strong step SSF. In the first substrate processing method, the second strong step SS2 corresponds to the final strong step SSF.

### First strong step SS1

When the replacing step S5 starts, the first strong step SS1 starts. The first strong step SS1 starts at the same time as the treating step S4 ends.

The first strong step SS1 is performed from the time t4 to a time t5.

In the first strong step SS1, the treating gas supply unit 11 does not supply the treating gas to the treatment space A. The inert gas supply unit 15 supplies the inert gas to the treatment space A. The exhaust unit 21 exhausts the gaseous body from the treatment space A.

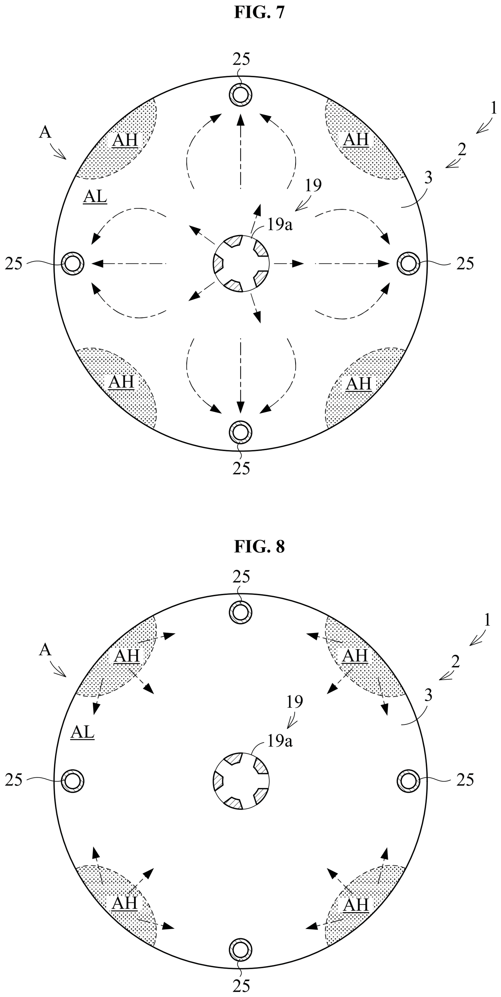

FIG. 7 is a drawing for explaining the treatment space A in the first strong step SS1. In the first strong step SS1, the flow of the gaseous body is generated in the treatment space A. The gaseous body in the treatment space A flows. For example, the gaseous body flows from the nozzle 19 to the exhaust ports 25 in the treatment space A. In FIG. 7, the flow of the gaseous body in the treatment space A is schematically indicated by an alternate long and short dash line.

The treating gas is exhausted from the treatment space A. The treating gas in the treatment space A is replaced with the inert gas.

The concentration of the treating gas in the treatment space A decreases. However, a local concentration of the treating gas may not uniformly decrease throughout the treatment space A. The local concentration of the treating gas may become nonuniform throughout the treatment space A. Here, the "local concentration of the treating gas" is the concentration of the treating gas in the gaseous body in a local area. The local area is a part of the treatment space A.

For example, in the first strong step SS1, the treatment space A includes a low-concentration area AL and a high-concentration area AH. Each of the low-concentration area AL and the high-concentration area AH is the local area of the treatment space A. The high-concentration area AH may be adjacent to the low-concentration area AL. For example, the local concentration of the treating gas include the concentration of the treating gas in the low-concentration area AL and the concentration of the treating gas in the high-concentration area AH.

The concentration of the treating gas in the low-concentration area AL is lower than the concentration of the treating gas in the high-concentration area AH. The concentration of the treating gas in the high-concentration area AH is higher than the concentration of the treating gas in the low-concentration area AL.

In the low-concentration area AL, it is easy to exhaust the treating gas from the treatment space A by the flow of the gaseous body in the treatment space A. In the low-concentration area AL, it is easy to appropriately replace the treating gas with the inert gas. It is easy to sufficiently lower the concentration of the treating gas in the low-concentration area AL.

Even in the high-concentration area AH, most of the treating gas in the high-concentration area AH is replaced with the inert gas. However, in the high-concentration area AH, it may not be easy to exhaust the treating gas from the treatment space by the flow of the gaseous body in the treatment space A. It may be easy for the treating gas to stay in the high-concentration area AH. It may be easy for the treating gas to remain in the high-concentration area AH. Therefore, in the high-concentration area AH, it may not be easy to appropriately replace the treating gas with the inert gas. It may not be easy to sufficiently lower the concentration of the treating gas in the high-concentration area AH.

### First weak step SW1

The first strong step SS1 and the first weak step SW1 are performed successively in time. The first weak step SW1 is performed immediately after the first strong step SS1. The first weak step SW1 starts at the same time as the first strong step SS1 ends.

The first weak step SW1 is performed in a period from the time t5 to a time t6.

In the first weak step SW1, the treating gas supply unit 11 does not supply the treating gas to the treatment space A. The inert gas supply unit 15 stops supplying the inert gas to the treatment space A. The exhaust unit 21 stops exhausting the gaseous body from the treatment space A.

FIG. 8 is a drawing for explaining the treatment space A in the first weak step. The flow of the gaseous body in the treatment space A in the first weak step SW1 is weaker than the flow of the gaseous body in the treatment space A in the first strong step SS1. For example, in the first weak step SW1, the flow of the gaseous body in the treatment space A disappears. In the first weak step SW1, the flow of the gaseous body in the treatment space A stops.

When the process proceeds from the first strong step SS1 to the first weak step SW1, the intensity of the flow of the gaseous body in the treatment space A changes with time. When the process proceeds from the first strong step SS1 to the first weak step SW1, the intensity of the flow of the gaseous body in the treatment space A decreases.

The temporal change of the intensity of the flow of the gaseous body in the treatment space A promotes diffusion of the treating gas in the treatment space A. The temporal change is rephrased as the change over time. The temporal change is rephrased as the time-dependent change. Therefore, in the first weak step SW1, the treating gas diffuses from the high-concentration area AH to the low-concentration area AL. In other words, in the first weak step SW1, it is difficult for the treating gas to keep staying in the high-concentration area AH of the treatment space A. As a result, in the first weak step SW1, the treating gas is uniformly distributed over the entire treatment space A. A difference between the concentration of the treating gas in the high-concentration area AH and the concentration of the treating gas in the low-concentration area AL is reduced. That is, a difference between the plurality of local concentrations of the treating gas is reduced.

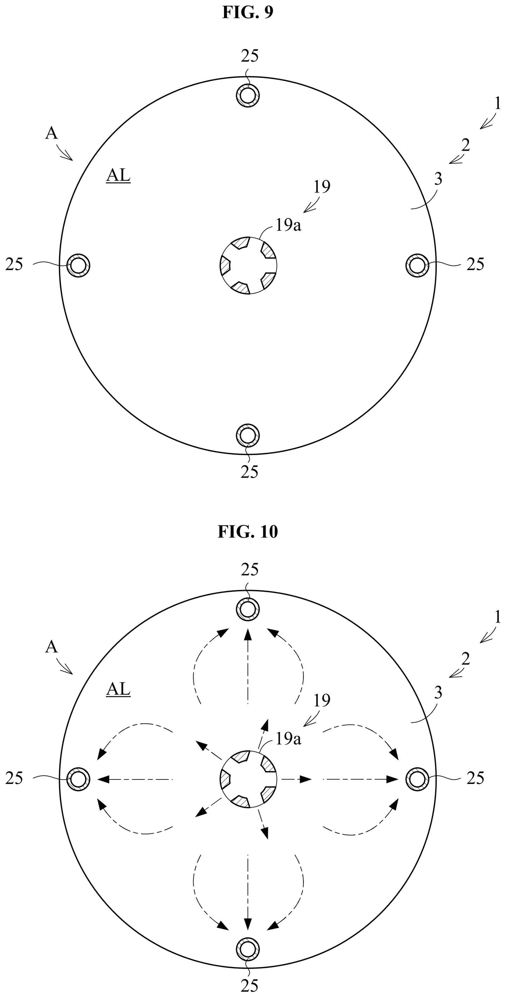

FIG. 9 is a drawing for explaining the treatment space A in the first weak step. For example, the high-concentration area AH disappears. The low-concentration area AL extends over the entire treatment space A. The local concentrations of the treating gas become uniform throughout the treatment space A.

### Second strong step SS2 (final strong step SSF)

The first weak step SW1 and the second strong step SS2 are performed successively in time. The second strong step SS2 is performed immediately after the first weak step SW1. The second strong step SS2 starts at the same time as the first weak step SW1 ends.

The second strong step SS2 is performed in a period from the time t6 to the time t7.

In the second strong step SS2, the treating gas supply unit 11 does not supply the treating gas to the treatment space A. The inert gas supply unit 15 supplies the inert gas to the treatment space A. The exhaust unit 21 exhausts the gaseous body from the treatment space A.

FIG. 10 is a drawing for explaining the treatment space A in the second strong step SS2. The flow of the gaseous body in the treatment space A in the second strong step SS2 is stronger than the flow of the gaseous body in the treatment space A in the first weak step SW1. For example, in the second strong step SS2, the flow of the gaseous body is generated in the treatment space A. The gaseous body in the treatment space A flows. For example, the gaseous body flows from the nozzle 19 to the exhaust ports 25 in the treatment space A. In FIG. 10, the flow of the gaseous body in the treatment space A is schematically indicated by an alternate long and short dash line.

When the process proceeds from the first weak step SW1 to the second strong step SS2, the intensity of the flow of the gaseous body in the treatment space A changes with time again. When the process proceeds from the first weak step SW1 to the second strong step SS2, the intensity of the flow of the gaseous body in the treatment space A increases. When the process proceeds from the first weak step SW1 to the second strong step SS2, the flow of the gaseous body in the treatment space A is generated again.

The diffusion of the treating gas in the treatment space A is promoted again. The difference between the plurality of local concentrations of the treating gas is further reduced. If the high-concentration area AH does not disappear in the first weak step SW1, the high-concentration area AH may disappear in the second strong step SS2.

Therefore, the treating gas is smoothly exhausted from the treatment space A. Staying of the treating gas in the local area of the treatment space A is effectively prevented or reduced. The concentration of the treating gas in the treatment space A efficiently decreases. The concentration of the treating gas in the treatment space A sufficiently decreases.

Reference is made to FIG. 6. In the replacing step S5, the pressure in the treatment space A increases with the lapse of time. Specifically, the pressure in the treatment space A increases with the lapse of time from the time t4 to the time t7.

In the replacing step S5, the pressure in the treatment space A increases from the pressure P4 to a pressure P7. The pressure P7 is the pressure in the treatment space A at the time t7. The pressure P7 is higher than the pressure P4. The pressure P7 is lower than the atmospheric pressure. The pressure P7 is lower than the pressure P1.

The pressure in the treatment space A at the end of the replacing step S5 is higher than the pressure in the treatment space A at the start of the replacing step S5. The pressure P4 corresponds to the pressure in the treatment space A at the start of the replacing step S5. The pressure P7 corresponds to the pressure in the treatment space A at the end of the replacing step S5.

In the first strong step SS1, the pressure in the treatment space A increases with the lapse of time. Specifically, the pressure in the treatment space A increases with the lapse of time from the time t4 to the time t5. In the first strong step SS1, the pressure in the treatment space A increases from the pressure P4 to a pressure P5. The pressure P5 is the pressure in the treatment space A at the time t5. The pressure P5 is higher than the pressure P4. The pressure P5 is lower than the pressure P7. The pressure P5 is lower than the atmospheric pressure. The pressure P5 is lower than the pressure P1.

In the first weak step SW1, the pressure in the treatment space A is kept constant. Specifically, the pressure in the treatment space A is kept constant from the time t5 to the time t6. In the first weak step SW1, the pressure in the treatment space A is kept at the pressure P5. The pressure P5 is also the pressure in the treatment space A at the time t6.

In the second strong step SS2, the pressure in the treatment space A increases with the lapse of time. Specifically, the pressure in the treatment space A increases with the lapse of time from the time t6 to the time t7. In the second strong step SS2, the pressure in the treatment space A increases from the pressure P5 to the pressure P7.

The pressure in the treatment space A in the replacing step S5 is higher than the pressure in the treatment space A in the treating step S4.

The pressure in the treatment space A in the first strong step SS1 is higher than the pressure in the treatment space A in the treating step S4.

The pressure in the treatment space A in the second strong step SS2 is higher than the pressure in the treatment space A in the first strong step SS1. In other words, the pressure in the treatment space A in the final strong step SSF is higher than the pressure in the treatment space A in the first strong step SS1.

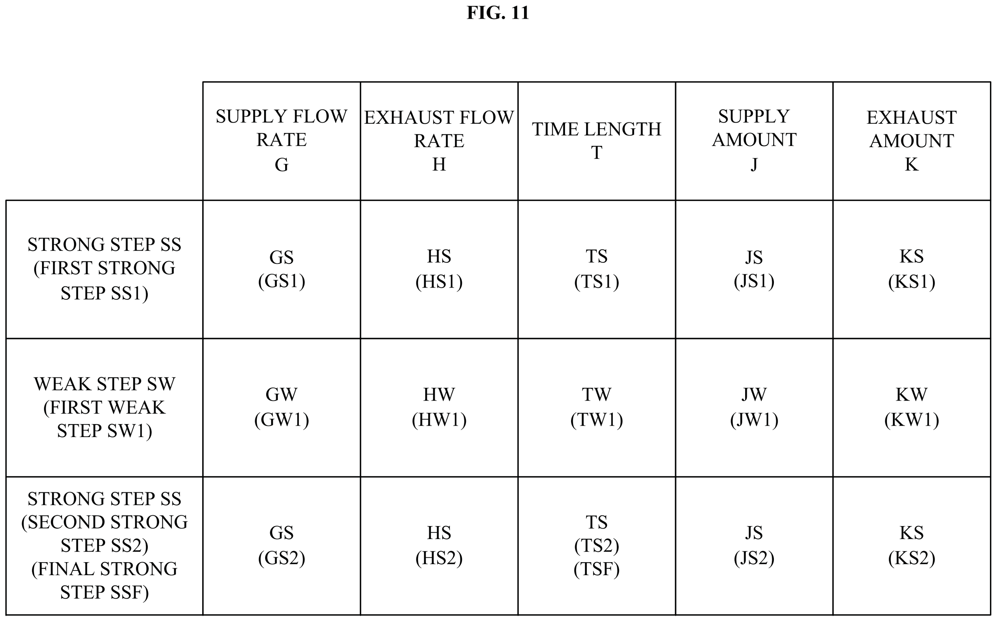

FIG. 11 is a drawing illustrating parameters of the replacing step S5. The supply flow rate G is one of the parameters of the replacing step S5. As described above, the supply flow rate G is the flow rate of the inert gas supplied to the treatment space A. The unit of the supply flow rate G is, for example, [L/min].

The exhaust flow rate H is one of the parameters of the replacing step S5. As described above, the exhaust flow rate H is the flow rate of the gaseous body exhausted from the treatment space A. The unit of the exhaust flow rate H is, for example, [L/min].

At least either the supply flow rate G or the exhaust flow rate H is different between the strong step SS and the weak step SW. At least either the supply flow rate G or the exhaust flow rate H is different between the strong step SS and the weak step SW performed successively in time. Specifically, at least either the supply flow rate G or the exhaust flow rate H is different between the first strong step SS1 and the first weak step SW1. At least either the supply flow rate G or the exhaust flow rate H is different between the first weak step SW1 and the second strong step SS2.

In the first substrate processing method, both the supply flow rate G and the exhaust flow rate H are different between the strong step SS and the weak step SW. Specifically, both the supply flow rate G and the exhaust flow rate H are different between the first strong step SS1 and the first weak step SW1. Both the supply flow rate G and the exhaust flow rate H are different between the first weak step SW1 and the second strong step SS2.

The supply flow rate G of the strong step SS is referred to as a supply flow rate GS. The supply flow rate G of the weak step SW is referred to as a supply flow rate GW. The supply flow rate GW is equal to or less than the supply flow rate GS.

In the first substrate processing method, the supply flow rate GW is different from the supply flow rate GS. In the first substrate processing method, the supply flow rate GW is lower than the supply flow rate GS.

The supply flow rate G of the first strong step SS1 is referred to as a supply flow rate GS1. The supply flow rate G of the first weak step SW1 is referred to as a supply flow rate GW1. The supply flow rate G of the second strong step SS2 is referred to as a supply flow rate GS2. The supply flow rate GW1 is equal to or less than the supply flow rate GS1. The supply flow rate GW1 is equal to or less than the supply flow rate GS2.

In the first substrate processing method, the supply flow rate GW1 is different from the supply flow rate GS1. The supply flow rate GW1 is lower than the supply flow rate GS1. The supply flow rate GW1 is different from the supply flow rate GS2. The supply flow rate GW1 is lower than the supply flow rate GS2.

The exhaust flow rate H of the strong step SS is referred to as an exhaust flow rate HS. The exhaust flow rate H of the weak step SW is referred to as an exhaust flow rate HW. The exhaust flow rate HW is equal to or less than the exhaust flow rate HS.

In the first substrate processing method, the exhaust flow rate HW is different from the exhaust flow rate HS. The exhaust flow rate HW is lower than the exhaust flow rate HS.

The exhaust flow rate H of the first strong step SS1 is referred to as an exhaust flow rate HS1. The exhaust flow rate H of the first weak step SW1 is referred to as an exhaust flow rate HW1. The exhaust flow rate H of the second strong step SS2 is referred to as an exhaust flow rate HS2. The exhaust flow rate HW1 is equal to or less than the exhaust flow rate HS1. The exhaust flow rate HW1 is equal to or less than the exhaust flow rate HS2.

In the first substrate processing method, the exhaust flow rate HW1 is different from the exhaust flow rate HS1. The exhaust flow rate HW1 is lower than the exhaust flow rate HS1. The exhaust flow rate HW1 is different from the exhaust flow rate HS2. The exhaust flow rate HW1 is lower than the exhaust flow rate HS2.

The supply flow rate G of the strong step SS, that is, the supply flow rate GS will be described. The supply flow rate GS is equal to or more than zero. The supply flow rate GS1 is equal to or more than zero. The supply flow rate GS2 is equal to or more than zero.

In the first substrate processing method, the supply flow rate GS is higher than zero. The supply flow rate GS1 is higher than zero. The supply flow rate GS2 is higher than zero.

The exhaust flow rate H of the strong step SS, that is, the exhaust flow rate HS will be described. The exhaust flow rate HS is equal to or more than zero. The exhaust flow rate HS1 is equal to or more than zero. The exhaust flow rate HS2 is equal to or more than zero.

In the first substrate processing method, the exhaust flow rate HS is higher than zero. The exhaust flow rate HS1 is higher than zero. The exhaust flow rate HS2 is higher than zero.

The supply flow rate G and the exhaust flow rate H of the weak step SW, that is, the supply flow rate GW and the exhaust flow rate HW will be described. At least either the supply flow rate GW or the exhaust flow rate HW is zero.

In the first substrate processing method, the supply flow rate GW is zero, and the exhaust flow rate HW is zero. The supply flow rate GW and the exhaust flow rate HW simultaneously become zero.

The parameters of the replacing step S5 include a time length T. The unit of the time length T is, for example, [s].

The time length T of the single strong step SS is referred to as a time length TS. The time length T of the single weak step SW is referred to as a time length TW. The time length TW is equal to or shorter than the time length TS. The time length TW is equal to or shorter than half the time length TS.

This will be described in more detail. The time length T of the first strong step SS1 is referred to as a time length TS1. The time length T of the first weak step SW1 is referred to as a time length TW1. The time length T of the second strong step SS2 is referred to as a time length TS2. The time length TW1 is equal to or shorter than the time length TS1. The time length TW1 is equal to or shorter than half the time length TS1. The time length TS2 is equal to or longer than the time length TW1. The time length TS2 is equal to or longer than twice the time length TW1.

The time length TS2 is equal to or longer than the time length TS1.

The time length T of the final strong step SSF is referred to as a time length TSF. The time length TSF is longer than the time length TS1. The time length TSF is equal to or longer than twice the time length TS1.

The sum of the time length TW is equal to or shorter than the sum of the time length TS. The sum of the time length TW is equal to or shorter than half the sum of the time length TS.

In the first substrate processing method, the sum of the time length TS corresponds to the sum of the time length TS1 and the time length TS2. The sum of the time length TW corresponds to the time length TW1.

In the first substrate processing method, the time length TS1 is a difference between the time t4 and the time t5. The time length TW1 is a difference between the time t5 and the time t6. The time length TS2 is a difference between the time t6 and the time t7. The time length TS2 corresponds to the time length TSF.

The parameters of the replacing step S5 include a supply amount J. The supply amount J is the amount of inert gas supplied to the treatment space A. The unit of the supply amount J is, for example, [L].

The parameters of the replacing step S5 include an exhaust amount K. The exhaust amount K is the amount of gaseous body exhausted from the treatment space A. The unit of the exhaust amount K is, for example, [L].

A difference between the supply amount J and the exhaust amount K in the single strong step SS is different from a difference between the supply amount J and the exhaust amount K in the single weak step SW.

This will be described specifically. The supply amount J of the single strong step SS is referred to as a supply amount JS. The exhaust amount K of the single strong step SS is referred to as an exhaust amount KS. The supply amount J of the single weak step SW is referred to as a supply amount JW. The exhaust amount K of the single weak step SW is referred to as an exhaust amount KW. A difference between the supply amount JW and the exhaust amount KW is different from a difference between the supply amount JS and the exhaust amount KS.

This will be described in more detail. The supply amount J of the first strong step SS1 is referred to as a supply amount JS1. The exhaust amount K of the first strong step SS1 is referred to as an exhaust amount KS1. The supply amount J of the first weak step SW1 is referred to as a supply amount JW1. The exhaust amount K of the first weak step SW1 is referred to as an exhaust amount KW1. The supply amount J of the second strong step SS2 is referred to as a supply amount JS2. The exhaust amount K of the second strong step SS2 is referred to as an exhaust amount KS2. A difference between the supply amount JW1 and the exhaust amount KW1 is different from a difference between the supply amount JS1 and the exhaust amount KS1. A difference between the supply amount JS2 and the exhaust amount KS2 is different from the difference between the supply amount JW1 and the exhaust amount KW1.

Here, for example, the supply amount JS is the product of the supply flow rate GS and the time length TS. The exhaust amount KS is the product of the exhaust flow rate HS and the time length TS. The supply amount JW is the product of the supply flow rate GW and the time length TW. The exhaust amount KW is the product of the exhaust flow rate HW and the time length TW.

For example, The supply amount JS1 is the product of the supply flow rate GS1 and the time length TS1. The exhaust amount KS1 is the product of the exhaust flow rate HS1 and the time length TS1. The supply amount JW1 is the product of the supply flow rate GW1 and the time length TW1. The exhaust amount KW1 is the product of the exhaust flow rate HW1 and the time length TW1. The supply amount JS2 is the product of the supply flow rate GS2 and the time length TS2. The exhaust amount KS2 is the product of the exhaust flow rate HS2 and the time length TS2.

Furthermore, the supply amount J is different between the first strong step SS1 and the first weak step SW1. Specifically, the supply amount JW1 is different from the supply amount JS1. The supply amount JW1 is smaller than the supply amount JS1.

The exhaust amount K is different between the first strong step SS1 and the first weak step SW1. Specifically, the exhaust amount KW1 is different from the exhaust amount KS1. The exhaust amount KW1 is smaller than the exhaust amount KS1.

The supply amount J is different between the first weak step SW1 and the second strong step SS2. Specifically, the supply amount JS2 is different from the supply amount JW1. The supply amount JS2 is larger than the supply amount JW1.

The exhaust amount K is different between the first weak step SW1 and the second strong step SS2. Specifically, the exhaust amount KS2 is different from the exhaust amount KW1. The exhaust amount KS2 is larger than the exhaust amount KW1.

### Pressure restoration step S6

Reference is made to FIG. 6. The pressure in the treatment space A returns to the atmospheric pressure.

The pressure restoration step S6 is performed from the time t7 to a time t8.

In the pressure restoration step S6, the treatment space A is in a closed state.

The treating gas supply unit 11 does not supply the treating gas to the treatment space A. The inert gas supply unit 15 supplies the inert gas to the treatment space A. The exhaust unit 21 stops exhausting the gaseous body from the treatment space A.

For example, the pressure in the treatment space A increases to the atmospheric pressure. The pressure in the treatment space A increases from the pressure P7 to the pressure P1. The pressure P1 is also the pressure in the treatment space A at the time t8.

The pressure in the treatment space A in the replacing step S5 described above is lower than the pressure in the treatment space A in the pressure restoration step S6.

### Opening step S7

In the opening step S7, the treatment space A is opened.

Specifically, the lid driver 5 moves the lid 4. The lid 4 moves from the closed position C1 to the open position C2. The gap D is opened. The treatment space A communicates with the external space B through the gap D. The gaseous body in the treatment space A may flow into the external space B. The gaseous body in the treatment space A may reach the substrate transporting mechanism 27.

The substrate lifting mechanism 6 moves the substrate W from the treatment position E1 to the transport position E2. Specifically, the pins 7 ascend from the standby position F1 to the support position F2. The pins 7 support the substrate W. The substrate W moves away from the plate 3.

### Carry-out step S8

The substrate W is carried out of the treatment space A.

The substrate transporting mechanism 27 transports the substrate W from the treatment space A to the external space B through the gap D. Specifically, the hand driver 29 moves the hand 28. The hand 28 moves from the external space B to the treatment space A through the gap D. The hand 28 takes the substrate W on the pins 7. The hand 28 supports the substrate W. The substrate W moves away from the pins 7. The hand 28 exits from the treatment space A to the external space B through the gap D together with the substrate W. The substrate W moves from the treatment space A to the external space B. The substrate W is located in the external space B.

### <2-2. Second substrate processing method>

Reference is made to FIG. 5 for convenience. The second substrate processing method includes steps S1 to S8. The second substrate processing method is the same as the first substrate processing method in steps S1 to S4 and S6 to S8. The second substrate processing method is different from the first substrate processing method in the replacing step S5. Therefore, description of steps S1 to S4 and S6 to S8 is omitted. The replacing step S5 in the second substrate processing method will be described.

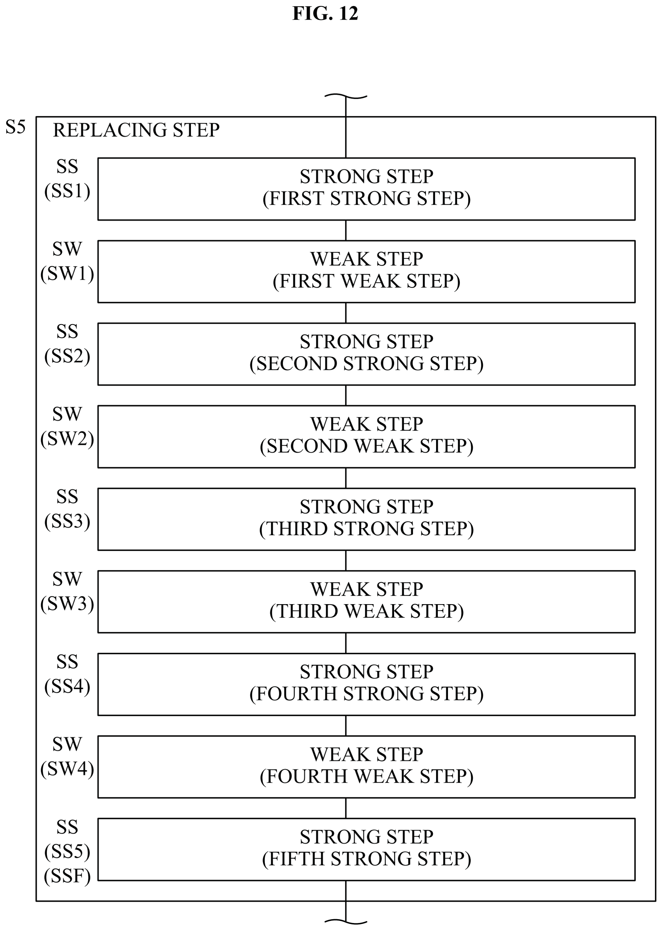

FIG. 12 is a flowchart illustrating a procedure of the second substrate processing method. More specifically, FIG. 12 is a flowchart illustrating a procedure of the replacing step S5 of the second substrate processing method. Note that the same configurations as those of the first substrate processing method are denoted by the same reference numerals, and detailed description thereof will be omitted.

### Replacing step S5

The replacing step S5 includes a strong step SS and a weak step SW. The number of strong steps SS included in the replacing step S5 is five. The number of weak steps SW included in the replacing step S5 is four.

When the five strong steps SS are distinguished, the respective strong steps SS are referred to as a first strong step SS1, a second strong step SS2, a third strong step SS3, a fourth strong step SS4, and a fifth strong step SS5. When the four weak steps SW are distinguished, the respective weak steps SW are referred to as a first weak step SW1, a second weak step SW2, a third weak step SW3, and a fourth weak step SW4.

The first strong step SS1 is performed first among the five strong steps SS. The first weak step SW1 is performed immediately after the first strong step SS1. The second strong step SS2 is performed immediately after the first weak step SW1. Thereafter, the second weak step SW2, the third strong step SS3, the third weak step SW3, the fourth strong step SS4, the fourth weak step SW4, and the fifth strong step SS5 are performed in this order.

In the second substrate processing method, the fifth strong step SS5 corresponds to the final strong step SSF.

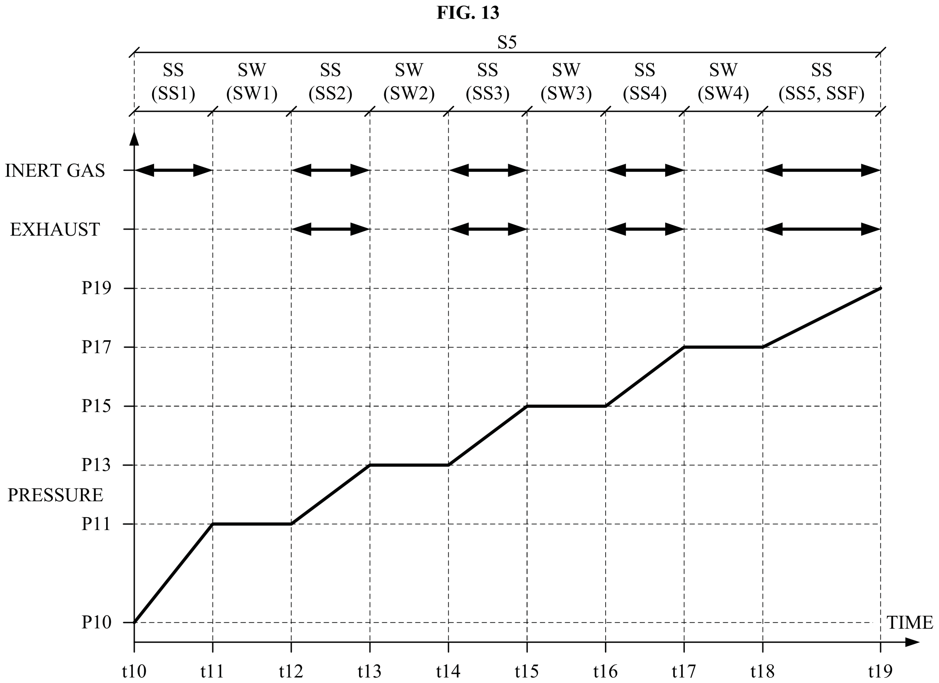

FIG. 13 is a timing chart of the second substrate processing method. FIG. 13 is a timing chart of the supply of the inert gas. FIG. 13 is a timing chart of the exhaust. FIG. 13 is a timing chart of the pressure in the treatment space A. The replacing step S5 is performed from a time t10 to a time t19.

In the replacing step S5, the treatment space A is in a closed state. In the replacing step S5, the pressure in the treatment space A is kept lower than the atmospheric pressure.

### First strong step SS1

The first strong step SS1 is performed from the time t10 to a time t11.

The inert gas supply unit 15 supplies the inert gas to the treatment space A. The exhaust unit 21 does not exhaust the gaseous body from the treatment space A.

As described above, the pressure in the treatment space A is kept lower than the atmospheric pressure. Therefore, it is easy for the inert gas supply unit 15 to supply the inert gas to the treatment space A even if the exhaust unit 21 does not exhaust the gaseous body from the treatment space A. The inert gas smoothly flows from the inert gas supply unit 15 to the treatment space A. Then, the pressure in the treatment space A quickly increases.

### First weak step SW1

The first weak step SW1 is performed from the time t11 to a time t12. The inert gas supply unit 15 stops supplying the inert gas to the treatment space A. The exhaust unit 21 does not exhaust the gaseous body from the treatment space A.

The supply flow rate G is different between the first weak step SW1 and the first strong step SS1. The supply flow rate G of the first weak step SW1 is lower than the supply flow rate G of the first strong step SS1. The exhaust flow rate H is the same between the first weak step SW1 and the first strong step SS1.

When the process proceeds from the first strong step SS1 to the first weak step SW1, the flow of the gaseous body in the treatment space A becomes weak. For example, when the process proceeds from the first strong step SS1 to the first weak step SW1, the flow of the gaseous body in the treatment space A stops.

### Second strong step SS2

The second strong step SS2 is performed from the time t12 to a time t13. The inert gas supply unit 15 restarts supplying the inert gas to the treatment space A. The exhaust unit 21 exhausts the gaseous body from the treatment space A.

The supply flow rate G is different between the second strong step SS2 and the first weak step SW1. The supply flow rate G of the second strong step SS2 is higher than the supply flow rate G of the first weak step SW1. The exhaust flow rate H is different between the second strong step SS2 and the first weak step SW1. The exhaust flow rate H of the second strong step SS2 is higher than the exhaust flow rate H of the first weak step SW1.

When the process proceeds from the first weak step SW1 to the second strong step SS2, the flow of the gaseous body in the treatment space A becomes strong. For example, when the process proceeds from the first weak step SW1 to the second strong step SS2, the flow of the gaseous body in the treatment space A is generated.

### Second weak step SW2

The second weak step SW2 is performed from the time t13 to a time t14. The inert gas supply unit 15 stops supplying the inert gas to the treatment space A. The exhaust unit 21 stops exhausting the gaseous body from the treatment space A.

When the process proceeds from the second strong step SS2 to the second weak step SW2, the flow of the gaseous body in the treatment space A becomes weak again. For example, when the process proceeds from the second strong step SS2 to the second weak step SW2, the flow of the gaseous body in the treatment space A stops again.

### Third strong step SS3

The third strong step SS3 is performed from the time t14 to a time t15. The inert gas supply unit 15 restarts supplying the inert gas to the treatment space A. The exhaust unit 21 restarts exhausting the gaseous body from the treatment space A.

When the process proceeds from the second weak step SW2 to the third strong step SS3, the flow of the gaseous body in the treatment space A becomes strong again. For example, when the process proceeds from the second weak step SW2 to the third strong step SS3, the flow of the gaseous body in the treatment space A is generated again.

### Third weak step SW3 to fifth strong step SS5

Thereafter, the weak step SW and the strong step SS are alternately repeated in a similar manner. The third weak step SW3 to the fifth strong step SS5 is similar to the first weak step SW1 to the third strong step SS3. In the weak step SW, the inert gas supply unit 15 stops supplying the inert gas to the treatment space A, and the exhaust unit 21 stops exhausting the gaseous body from the treatment space A. In the strong step SS, the inert gas supply unit 15 restarts supplying the inert gas to the treatment space A, and the exhaust unit 21 restarts exhausting the gaseous body from the treatment space A.

In the replacing step S5, the pressure in the treatment space A gradually increases.

In the replacing step S5, the pressure in the treatment space A increases from a pressure P10 to a pressure P19. The pressure P10 is the pressure in the treatment space A at the time t10. The pressure P19 is the pressure in the treatment space A at the time t19. The pressure P10 is lower than the atmospheric pressure. The pressure P19 is lower than the atmospheric pressure. The pressure P19 is higher than the pressure P10.

In the strong step SS, the pressure in the treatment space A increases. In the weak step SW, the pressure in the treatment space A is kept constant.

For example, in the first strong step SS1, the pressure in the treatment space A increases from the pressure P10 to a pressure P11. In the first weak step SW1, the pressure in the treatment space A is kept at the pressure P11. In the second strong step SS2, the pressure in the treatment space A increases from the pressure P11 to a pressure P13. In the second weak step SW2, the pressure in the treatment space A is kept at the pressure P13.

Here, the pressure P11 is the pressure in the treatment space A at the time t11. The pressure P11 is also the pressure in the treatment space A at the time t12. The pressure P11 is higher than the pressure P10. The pressure P11 is lower than the atmospheric pressure. The pressure P11 is lower than the pressure P19. The pressure P13 is the pressure in the treatment space A at the time t13. The pressure P13 is also the pressure in the treatment space A at the time t14. The pressure P13 is higher than the pressure P11. The pressure P13 is lower than the atmospheric pressure. The pressure P13 is lower than the pressure P19.

In the first strong step SS1, the pressure in the treatment space A relatively rapidly increases. In the second strong step SS2, the pressure in the treatment space A relatively gently increases. Similarly, in the third strong step SS3, the fourth strong step SS4, and the fifth strong step SS5, the pressure in the treatment space A relatively gently increases.

The pressure in the treatment space A in the second strong step SS2 is higher than the pressure in the treatment space A in the first strong step SS1. Similarly, the pressure in the treatment space A in the third strong step SS3 is higher than the pressure in the treatment space A in the second strong step SS2. The pressure in the treatment space A in the fourth strong step SS4 is higher than the pressure in the treatment space A in the third strong step SS3. The pressure in the treatment space A in the fifth strong step SS5 is higher than the pressure in the treatment space A in the fourth strong step SS4.

### <3. Technical significance of replacing step S5>

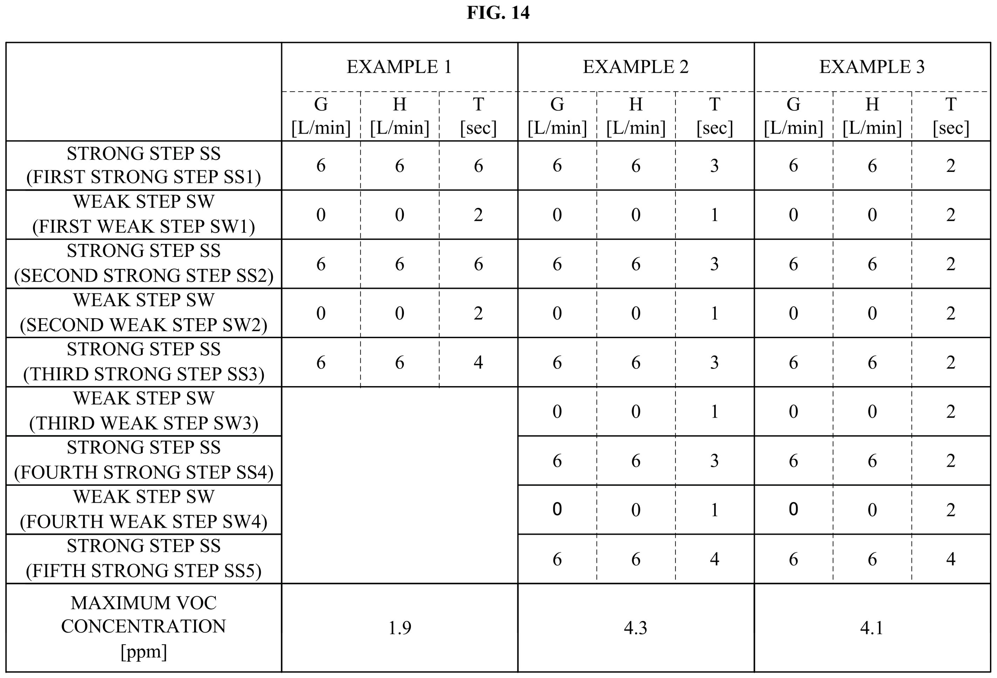

FIG. 14 is a table illustrating Examples 1 to 3. Each of Examples 1 to 3 is an example of the replacing step S5 of the embodiment. The technical significance of the replacing step S5 will be described with reference to Examples 1 to 3.

In each of Examples 1 to 3, the treating gas in the treatment space A is replaced with the inert gas. The treating gas contains hexamethyldisilazane (HMDS). The inert gas contains nitrogen.

Conditions of Example 1 will be described. Example 1 includes three strong steps SS and two weak steps SW. In a case where the three strong steps SS are distinguished, they are referred to as a first strong step SS1, a second strong step SS2, and a third strong step SS3. In a case where the two weak steps SW are distinguished, they are referred to as a first weak step SW1 and a second weak step SW2.

Parameters of each strong step SS and each weak step SW are as illustrated in FIG. 14. For example, in the first strong step SS1, the supply flow rate G is 6 [L/min], the exhaust flow rate H is 6 [L/min], and the time length T is 6 [sec]. In the first weak step SW1, the supply flow rate G is 0 [L/min], the exhaust flow rate H is 0 [L/min], and the time length T is 2 [sec].

Conditions of Examples 2 and 3 will be described. Each of Examples 2 and 3 includes five strong steps SS and four weak steps SW. In a case where the five strong steps SS are distinguished, they are referred to as a first strong step SS1, a second strong step SS2, a third strong step SS3, a fourth strong step SS4, and a fifth strong step SS5. In a case where the four weak steps SW are distinguished, they are referred to as a first weak step SW1, a second weak step SW2, a third weak step SW3, and a fourth weak step SW4.

Parameters of each strong step SS and each weak step SW are as illustrated in FIG. 14. For example, in the first strong step SS1 of Example 2, the supply flow rate G is 6 [L/min], the exhaust flow rate H is 6 [L/min], and the time length T is 3 [sec]. In the first strong step SS1 of Example 3, the supply flow rate G is 6 [L/min], the exhaust flow rate H is 6 [L/min], and the time length T is 2 [sec].

Examples 1 to 3 were evaluated on the basis of a VOC concentration. VOC is an abbreviation for volatile organic compound. The unit of the VOC concentration is, for example, [ppm]. The VOC concentration is detected by a VOC sensor. For example, the VOC sensor is installed in the external space B. The VOC sensor is disposed in the vicinity of the treatment space A. For example, the VOC sensor is installed in the vicinity of the gap D. After execution of Examples 1 to 3, the treatment space A is opened. When the treatment space A is opened, the VOC sensor measures the VOC concentration. As a result, measurement data of the VOC concentration is obtained. A maximum value of the measurement data of the VOC concentration is referred to as a maximum VOC concentration.

FIG. 14 illustrates the maximum VOC concentrations of Examples 1 to 3. The maximum VOC concentration of Example 1 was 1.9 [ppm]. The maximum VOC concentration of Example 2 was 4.3 [ppm]. The maximum VOC concentration of Example 3 was 4.1 [ppm].

In all of Examples 1 to 3, the maximum VOC concentration was sufficiently low. Therefore, in Examples 1 to 3, the treating gas in the treatment space A was appropriately replaced with the inert gas.

The evaluation results of Examples 1 to 3 confirm that the treating gas in the treatment space A is appropriately replaced with the inert gas in the replacing step S5 of the embodiment.

### <4. Effects of embodiment>

The substrate processing method includes the treating step S4, the replacing step S5, and the pressure restoration step S6. In the treating step S4, the treating gas is supplied to the treatment space A. The treatment space A accommodates the substrate W. Therefore, in the treating step S4, the treating gas is supplied to the substrate W. In the replacing step S5, the pressure in the treatment space A is lower than the atmospheric pressure. That is, in the replacing step S5, the pressure in the treatment space A is kept lower than the atmospheric pressure. In the replacing step S5, the inert gas is supplied to the treatment space A. In the replacing step S5, the gaseous body is exhausted from the treatment space A. In the pressure restoration step S6, the pressure in the treatment space A returns to the atmospheric pressure.

The flow rate of the inert gas supplied to the treatment space A is defined as the supply flow rate G. The flow rate of the gaseous body exhausted from the treatment space A is defined as the exhaust flow rate H. In the replacing step S5, at least either the supply flow rate G or the exhaust flow rate H changes with time. Therefore, the intensity of the flow of the gaseous body in the treatment space A changes with time. Here, the temporal change of the intensity of the flow of the gaseous body in the treatment space A promotes the diffusion of the treating gas in the treatment space A. This makes it easy for the treating gas to diffuse throughout the treatment space A in the replacing step S5. It is difficult for the treating gas to stay in the local area of the treatment space A in the replacing step S5. Therefore, it is easy to make the local concentrations of the treating gas uniform throughout the treatment space A in the replacing step S5. It is easy to reduce the difference between the local concentrations of the treating gas in the replacing step S5. As a result, it is easy to appropriately replace the treating gas in the treatment space A with the inert gas in the replacing step S5. It is easy to sufficiently exhaust the treating gas from the treatment space A in the replacing step S5.

In summary, the substrate processing method appropriately replaces the treating gas with the inert gas.

As described above, the treating gas in the treatment space A is appropriately replaced with the inert gas. Therefore, remaining of the treating gas in the treatment space A after the replacing step S5 is appropriately prevented or reduced. Therefore, even in a case where the treatment space A is opened, leakage of the treating gas is appropriately prevented or reduced. For example, also in the opening step S7, the treating gas does not leak.

For example, the treating gas does not leak from the treatment space A to the external space B through the gap D. The external space B is not contaminated with the treating gas. The external space B is kept clean. As a result, the substrate W is not contaminated in the external space B.

For example, the treating gas does not reach the substrate transporting mechanism 27. The substrate transporting mechanism 27 is not contaminated with the treating gas. The substrate transporting mechanism 27 is kept clean. As a result, the transport quality of the substrate W by the transporting mechanism 27 does not deteriorate.

For example, the treating gas does not reach another equipment for treating the substrate. The other equipment for treating the substrate is not contaminated with the treating gas. The other equipment for treating the substrate is kept clean. As a result, the treatment quality of the substrate W by the other equipment does not deteriorate. Here, the "other equipment" is, for example, equipment disposed outside the treatment container 2. The "other equipment" is, for example, equipment disposed outside the treatment space A. The "other equipment" is, for example, equipment disposed in the external space B.

In the replacing step S5, at least either the supply flow rate G or the exhaust flow rate H temporarily changes to zero. Therefore, it is easy to time-dependently change at least either the supply flow rate G or the exhaust flow rate H in the replacing step S5. This makes it easy to time-dependently change the intensity of the flow of the gaseous body in the treatment space A in the replacing step S5. Therefore, it is easy to appropriately replace the treating gas in the treatment space A with the inert gas in the replacing step S5.

In the replacing step S5, the inert gas is intermittently supplied to the treatment space A. Therefore, it is easy to time-dependently change the supply flow rate G in the replacing step S5. This makes it easy to time-dependently change the intensity of the flow of the gaseous body in the treatment space A in the replacing step S5. Therefore, it is easy to appropriately replace the treating gas in the treatment space A with the inert gas in the replacing step S5.

In the replacing step S5, the gaseous body in the treatment space A is intermittently exhausted. Therefore, it is easy to time-dependently change the exhaust flow rate H in the replacing step S5. This makes it easy to time-dependently change the intensity of the flow of the gaseous body in the treatment space A in the replacing step S5. Therefore, it is easy to appropriately replace the treating gas in the treatment space A with the inert gas in the replacing step S5.

In the replacing step S5, the inert gas is supplied to the treatment space A, and then the supply flow rate G changes to zero. Therefore, it is easy to time-dependently change the supply flow rate G in the replacing step S5. This makes it easy to time-dependently change the intensity of the flow of the gaseous body in the treatment space A in the replacing step S5. Therefore, it is easy to appropriately replace the treating gas in the treatment space A with the inert gas in the replacing step S5.

In the replacing step S5, the inert gas is supplied to the treatment space A, and then both the supply flow rate G and the exhaust flow rate H simultaneously change to zero. Therefore, it is easy to generate the flow of the gaseous body in the treatment space A. It is easy to stop the flow of the gaseous body in the treatment space A after generating the flow of the gaseous body in the treatment space A. For example, it is easy to create the flow of the gaseous body in the treatment space A and then stop the flow of the gaseous body in the treatment space A. Here, stopping the flow of the gaseous body in the treatment space A further promotes the diffusion of the treating gas in the treatment space A. This makes it easier for the treating gas to diffuse throughout the treatment space A in the replacing step S5. Therefore, it is easier to make the local concentrations of the treating gas uniform throughout the treatment space A in the replacing step S5. It is easier to reduce the difference between the local concentrations of the treating gas in the replacing step S5. As a result, it is easier to appropriately replace the treating gas in the treatment space A with the inert gas in the replacing step S5.

The replacing step S5 includes the strong step SS and the weak step SW. The strong step SS and the weak step SW are alternately executed. At least either the supply flow rate G or the exhaust flow rate H is different between the strong step SS and the weak step SW. Therefore, when the strong step SS and the weak step SW are alternately executed, at least either the supply flow rate G or the exhaust flow rate H changes. For example, the supply flow rate G is different between the strong step SS and the weak step SW, and the exhaust flow rate H is the same between the strong step SS and the weak step SW. Alternatively, the supply flow rate G is the same between the strong step SS and the weak step SW, and the exhaust flow rate H is different between the strong step SS and the weak step SW. Alternatively, the supply flow rate G is different between the strong step SS and the weak step SW, and the exhaust flow rate H is different between the strong step SS and the weak step SW. In any case, when the strong step SS and the weak step SW are alternately executed, at least either the supply flow rate G or the exhaust flow rate H changes. Therefore, it is easy to time-dependently change at least either the supply flow rate G or the exhaust flow rate H in the replacing step S5. This makes it easy to time-dependently change the intensity of the flow of the gaseous body in the treatment space A in the replacing step S5. Therefore, it is easy to appropriately replace the treating gas in the treatment space A with the inert gas in the replacing step S5.

The supply flow rate GW is equal to or less than the supply flow rate GS. The exhaust flow rate HW is equal to or less than the exhaust flow rate HS. In other words, the supply flow rate G of the weak step SW is equal to or less than the supply flow rate G of the strong step SS. The exhaust flow rate H of the weak step SW is equal to or less than the exhaust flow rate H of the strong step SS. Therefore, it is easy to make at least either the supply flow rate G or the exhaust flow rate H different between the strong step SS and the weak step SW. For example, the supply flow rate GW is the same as the supply flow rate GS, and the exhaust flow rate HW is smaller than the exhaust flow rate HW. Alternatively, the supply flow rate GW is smaller than the supply flow rate GS, and the exhaust flow rate HW is the same as the exhaust flow rate HS. Alternatively, the supply flow rate GW is smaller than the supply flow rate GS, and the exhaust flow rate HW is smaller than the exhaust flow rate HS. In any case, at least either the supply flow rate G or the exhaust flow rate H is different between the strong step SS and the weak step SW.

As described above, the supply flow rate GW is equal to or less than the supply flow rate GS. The exhaust flow rate HW is equal to or less than the exhaust flow rate HS. In other words, the supply flow rate G of the weak step SW is equal to or less than the supply flow rate G of the strong step SS. The exhaust flow rate H of the weak step SW is equal to or less than the exhaust flow rate H of the strong step SS. Therefore, it is easy to weaken or stop the flow of the gaseous body in the treatment space A in the weak step SW. It is easy to generate or strengthen the flow of the gaseous body in the treatment space A in the strong step SS.

At least either the supply flow rate GW or the exhaust flow rate HW is zero. In other words, in the weak step SW, at least either the supply flow rate G or the exhaust flow rate H is zero. Therefore, it is easy to weaken or stop the flow of the gaseous body in the treatment space A in the weak step SW.

The supply flow rate GW is zero. In other words, in the weak step SW, the supply flow rate G is zero. Therefore, it is easy to make the supply flow rate GW equal to or less than the supply flow rate GS.

The exhaust flow rate HW is zero. In other words, in the weak step SW, the exhaust flow rate H is zero. Therefore, it is easy to make the exhaust flow rate HW equal to or less than the exhaust flow rate HS.

The supply flow rate GW is zero, and the exhaust flow rate HW is zero. In other words, in the weak step SW, the supply flow rate G is zero and the exhaust flow rate H is zero. Therefore, it is easier to make the supply flow rate GW equal to or less than the supply flow rate GS. It is easier to make the exhaust flow rate HW equal to or less than the exhaust flow rate HS.

As described above, the supply flow rate GW is zero, and the exhaust flow rate HW is zero. Therefore, it is easier to stop the flow of the gaseous body in the treatment space A in the weak step SW. This makes it easier for the treating gas to diffuse throughout the treatment space A in the weak step SW. Therefore, it is easier to make the local concentrations of the treating gas uniform throughout the treatment space A in the weak step SW. It is easier to reduce the difference between the local concentrations of the treating gas in the weak step SW. As a result, it is easier to appropriately replace the treating gas in the treatment space A with the inert gas in the replacing step S5.

The time length TW is equal to or shorter than the time length TS. In other words, the time length T of the single weak step SW is equal to or shorter than the time length T of the single strong step SS. Therefore, it is easy to shorten the time length of the weak step SW. This makes it easy to shorten the time length of the replacing step S5. Furthermore, it is easy to lengthen the time length of the strong step SS. This makes it easy to appropriately replace the treating gas in the treatment space A with the inert gas in the replacing step S5. In summary, it is easy to efficiently replace the treating gas in the treatment space A with the inert gas in the replacing step S5.

The time length TW is equal to or shorter than half the time length TS. In other words, the time length T of the single weak step SW is equal to or shorter than half the time length T of the single strong step SS. Therefore, it is easier to shorten the time length of the weak step SW. This makes it easier to shorten the time length of the replacing step S5. Furthermore, it is easier to lengthen the time length of the strong step SS. This makes it easier to appropriately replace the treating gas in the treatment space A with the inert gas in the replacing step S5. In summary, it is easier to efficiently replace the treating gas in the treatment space A with the inert gas in the replacing step S5.

The number of strong steps SS included in the replacing step S5 is two or more. The number of weak steps SW included in the replacing step S5 is one or more. Therefore, it is easy to alternately execute the strong step SS and the weak step SW.

For example, the number of strong steps SS included in the replacing step S5 is four or more. The number of weak steps SW included in the replacing step S5 is three or more. Therefore, it is easy to alternately and repeatedly execute the strong step SS and the weak step SW. This makes it easy to increase the number of times of temporally changing at least either the supply flow rate G or the exhaust flow rate H in the replacing step S5. In other words, this makes it easy to increase the number of times of time-dependently changing at least either the supply flow rate G or the exhaust flow rate H in the replacing step S5. Thus, it is easy to increase the number of times of temporally changing the intensity of the flow of the gaseous body in the treatment space A in the replacing step S5. In other words, it is easy to increase the number of times of time-dependently changing the intensity of the flow of the gaseous body in the treatment space A in the replacing step S5. Therefore, it is easier to appropriately replace the treating gas in the treatment space A with the inert gas in the replacing step S5.

The amount of inert gas supplied to the treatment space A is defined as the supply amount J. The amount of gaseous body exhausted from the treatment space A is defined as the exhaust amount K. The difference between the supply amount J and the exhaust amount K in the single weak step SW is different from the difference between the supply amount J and the exhaust amount K in the single strong step SS. Here, the difference between the supply amount J and the exhaust amount K affects the pressure in the treatment space A. Therefore, it is easy to make the pressure in the treatment space A in the weak step SW different from the pressure in the treatment space A in the strong step SS. This makes it easy to temporally change the pressure in the treatment space A in the replacing step S5. Here, the temporal change of the pressure in the treatment space A promotes the diffusion of the treating gas. This makes it easier for the treating gas to diffuse throughout the treatment space A in the replacing step S5. Therefore, it is easier to make the local concentrations of the treating gas uniform throughout the treatment space A in the replacing step S5. It is easier to reduce the difference between the local concentrations of the treating gas in the replacing step S5. As a result, it is easier to appropriately replace the treating gas in the treatment space A with the inert gas in the replacing step S5.

The first strong step SS1 is one of the strong steps SS. The first strong step SS1 is performed first among the plurality of strong steps SS. The first weak step SW1 is one of the weak steps SW. The first weak step SW1 is performed immediately after the first strong step SS1. The flow of the gaseous body in the treatment space A in the first weak step SW1 is weaker than the flow of the gaseous body in the treatment space A in the first strong step SS1. Therefore, the intensity of the flow of the gaseous body in the treatment space A changes between the first strong step SS1 and the first weak step SW1. This makes it easy to time-dependently change the intensity of the flow of the gaseous body in the treatment space A in the replacing step S5. Therefore, it is easy to appropriately replace the treating gas in the treatment space A with the inert gas in the replacing step S5.

The second strong step SS2 is one of the strong steps SS. The second strong step SS2 is performed immediately after the first weak step SW1. The flow of the gaseous body in the treatment space A in the second strong step SS2 is stronger than the flow of the gaseous body in the treatment space A in the first weak step SW1. Therefore, the intensity of the flow of the gaseous body in the treatment space A changes between the first weak step SW1 and the second strong step SS2. This makes it easy to time-dependently change the intensity of the flow of the gaseous body in the treatment space A in the replacing step S5. Therefore, it is easy to appropriately replace the treating gas in the treatment space A with the inert gas in the replacing step S5.

The final strong step SSF is one of the strong steps SS. The final strong step SSF is performed last among the plurality of strong steps SS. The time length T of the final strong step SSF is longer than the time length T of the first strong step SS1. That is, the time length TSF is longer than the time length TS1. Therefore, it is easy to sufficiently exhaust the treating gas from the treatment space A in the final strong step SSF. Therefore, it is easy to appropriately replace the treating gas in the treatment space A with the inert gas in the replacing step S5.

The pressure in the treatment space A in the final strong step SSF is higher than the pressure in the treatment space A in the first strong step SS1. Therefore, it is easy to reduce a difference between the pressure in the treatment space A in the final strong step SSF and the atmospheric pressure. This makes it easy to reduce the difference between the pressure in the treatment space A and the atmospheric pressure when the replacing step S5 is switched to the pressure restoration step S6. In other words, it is easy to reduce the difference between the pressure in the treatment space A and the atmospheric pressure when the pressure restoration step S6 starts. Therefore, it is easy to restore the pressure in the treatment space A to the atmospheric pressure in the pressure restoration step S6.

The substrate processing apparatus 1 includes the treatment container 2, the treating gas supply unit 11, the inert gas supply unit 15, the exhaust unit 21, and the controller 31. The treatment container 2 is configured to accommodate the substrate W. The treating gas supply unit 11 is connected to the treatment container 2. The treating gas supply unit 11 is configured to supply the treating gas to the treatment container 2. The inert gas supply unit 15 is connected to the treatment container 2. The inert gas supply unit 15 is configured to supply the inert gas to the treatment container 2. The exhaust unit 21 is connected to the treatment container 2. The exhaust unit 21 is configured to exhaust the gaseous body from the treatment container 2. The controller 31 controls the treating gas supply unit 11, the inert gas supply unit 15, and the exhaust unit 21. The controller 31 executes the treating operation and the replacing operation. The treating operation is for treating the substrate W in the treatment container 2. The replacing operation is for replacing the treating gas in the treatment container 2 with the inert gas. In the treating operation, the treating gas supply unit 11 supplies the treating gas to the treatment container 2. In the treating operation, the substrate W in the treatment container 2 is treated with the treating gas. In the replacing operation, the inert gas supply unit 15 supplies the inert gas to the treatment container 2, and the exhaust unit 21 exhausts the gaseous body from the treatment container 2.

In the replacing operation, the controller 31 controls the inert gas supply unit 15 and the exhaust unit 21 to time-dependently change the intensity of the flow of the gaseous body in the treatment container 2. Here, the temporal change of the intensity of the flow of the gaseous body in the treatment container 2 promotes the diffusion of the treating gas in the treatment container 2. This makes it easy for the treating gas to diffuse throughout the treatment container 2 in the replacing operation. It is difficult for the treating gas to stay in the local area within the treatment container 2 in the replacing operation. Therefore, it is easy to make the local concentrations of the treating gas uniform throughout the treatment container 2 in the replacing operation. It is easy to reduce the difference between the local concentrations of the treating gas in the replacing operation. As a result, it is easy to appropriately replace the treating gas in the treatment container 2 with the inert gas in the replacing operation. It is easy to sufficiently exhaust the treating gas from the treatment container 2 in the replacing operation.

In summary, the substrate processing apparatus 1 appropriately replaces the treating gas with the inert gas.

In the replacing operation, the controller 31 controls the inert gas supply unit 15 and the exhaust unit 21 to intermittently stop the flow of the gaseous body in the treatment container 2. This makes it easy for the controller 31 to time-dependently change the intensity of the flow of the gaseous body in the treatment container 2 in the replacing operation. Therefore, it is easy to appropriately replace the treating gas in the treatment container 2 with the inert gas in the replacing operation.

Furthermore, when the flow of the gaseous body in the treatment container 2 stops, it is easier for the treating gas to diffuse throughout the treatment container 2. Therefore, it is easier to make the local concentrations of the treating gas uniform throughout the treatment container 2 in the replacing operation. It is easier to reduce the difference between the local concentrations of the treating gas in the replacing operation. As a result, it is easier to appropriately replace the treating gas in the treatment container 2 with the inert gas in the replacing operation.

### <5. Modification>

This invention is not limited to the embodiment, and can be modified as follows.
(1) In the replacing step S5, either the supply flow rate G or the exhaust flow rate H may not change with time. In other words, in the replacing step S5, either the supply flow rate G or the exhaust flow rate H may be constant. For example, in the replacing step S5, the supply flow rate G may not change with time, and the exhaust flow rate H may change with time. Alternatively, in the replacing step S5, the supply flow rate G may change with time, and the exhaust flow rate H may not change with time.
(2) In the replacing step S5, the strong step SS and the weak step SW may not be divided. In the replacing step S5, it is sufficient if at least either the supply flow rate G or the exhaust flow rate H changes with time.

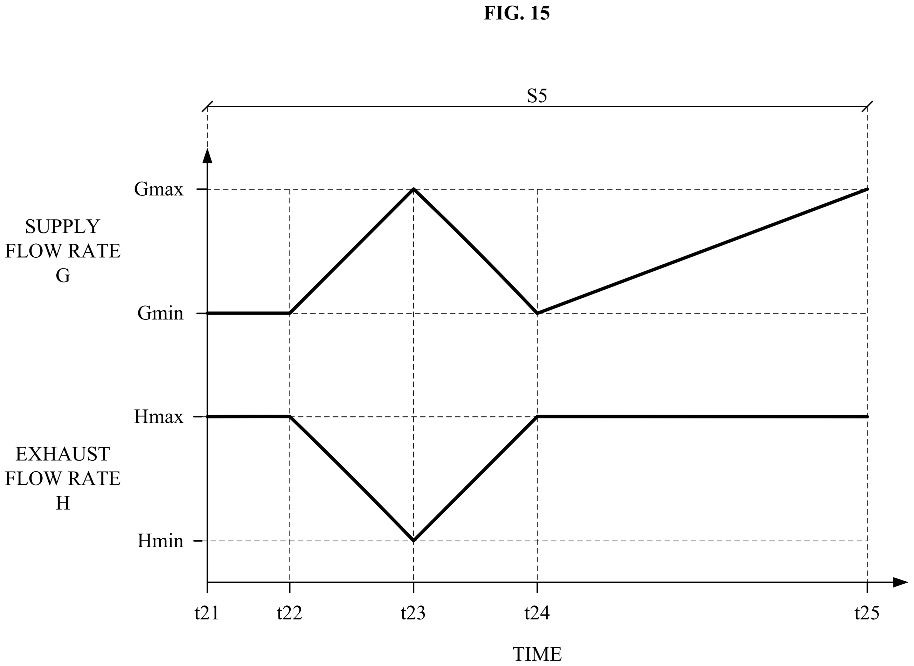

FIG. 15 is a timing chart of the supply flow rate G and the exhaust flow rate H according to a modification. Note that the same configurations as those of the embodiment are denoted by the same reference numerals, and detailed description thereof will be omitted.

The replacing step S5 is performed from a time t21 to a time t25. In the replacing step S5, the supply flow rate G changes between a minimum value Gmin and a maximum value Gmax. The maximum value Gmax is higher than the minimum value Gmin. In the replacing step S5, the exhaust flow rate H changes between a minimum value Hmin and a maximum value Hmax. The maximum value Hmax is higher than the minimum value Hmin.

Specifically, in the replacing step S5, the supply flow rate G changes from a time t22 to the time t25. In the replacing step S5, the exhaust flow rate H changes from the time t22 to a time t24.

More specifically, from the time t21 to the time t22, the supply flow rate G is kept at the minimum value Gmin. From the time t22 to a time t23, the supply flow rate G increases from the minimum value Gmin to the maximum value Gmax. From the time t23 to the time t24, the supply flow rate G decreases from the maximum value Gmax to the minimum value Gmin. From the time t24 to the time t25, the supply flow rate G increases from the minimum value Gmin to the maximum value Gmax.

From the time t21 to the time t22, the exhaust flow rate H is kept at the maximum value Hmax. From the time t22 to the time t23, the exhaust flow rate H decreases from the maximum value Hmax to the minimum value Hmin. From the time t23 to the time t24, the exhaust flow rate H increases from the minimum value Hmin to the maximum value Hmax. From the time t24 to the time t25, the exhaust flow rate H is kept at the maximum value Hmax.

In the present modification, it is difficult to specify the strong step SS and the weak step SW. For example, it is difficult to specify which period is the strong step SS and which period is the weak step SW.

However, also in the present modification, at least either the supply flow rate G or the exhaust flow rate H changes with time. Therefore, the intensity of the flow of the gaseous body in the treatment space A changes with time. Therefore, the treating gas is appropriately replaced with the inert gas.

(3) The supply flow rate G of the strong step SS may be zero. That is, the supply flow rate GS may be zero. For example, the supply flow rate GS1 may be zero. For example, at least either the supply flow rate GS1 or GS2 may be zero. For example, at least one of the supply flow rate GS1, GS2, or GS3 may be zero. For example, at least one of the supply flow rate GS1, GS2, GS3, or GS4 may be zero.

(4) The exhaust flow rate H of the strong step SS may be zero. That is, the exhaust flow rate HS may be zero. For example, the exhaust flow rate HS1 may be zero. For example, at least either the exhaust flow rate HS1 or HS2 may be zero. For example, at least one of the exhaust flow rate HS1, HS2, or HS3 may be zero. For example, at least one of the exhaust flow rate HS1, HS2, HS3, or HS4 may be zero.

(5) The supply flow rate G of the weak step SW may be greater than zero. That is, the supply flow rate GW may be greater than zero. For example, the supply flow rate GW1 may be greater than zero. For example, at least one of the supply flow rate GW1, GW2, GW3, or GW4 may be greater than zero.

(6) The exhaust flow rate H of the weak step SW may be greater than zero. That is, the exhaust flow rate HW may be greater than zero. For example, the exhaust flow rate HW1 may be greater than zero. For example, at least one of the exhaust flow rate HW1, HW2, HW3, or HW4 may be greater than zero.

(7) The treatment container 2 may be appropriately changed.

Although not illustrated, the treatment container 2 may include a container body and a shutter. The container body defines the treatment space A. The container body has an opening. The shutter is configured to be able to close the opening of the container body.

Furthermore, the substrate processing apparatus 1 may include a shutter driver. The shutter driver moves the shutter to a closed position and an open position. When the shutter is located at the closed position, the shutter closes the opening of the container body. When the shutter closes the opening of the container body, the treatment space A is isolated from the external space B. When the shutter is located at the open position, the shutter opens the opening of the container body. When the shutter opens the opening of the container body, the treatment space A communicates with the external space B through the opening of the container body. When the shutter opens the opening of the container body, the substrate W and the hand 28 can pass through the opening of the container body.

(8) The plate 3 may be appropriately changed.

For example, the circumferential portion 3a and the support portion 3b may be integrated. The circumferential portion 3a and the support portion 3b may be inseparable.

Alternatively, the circumferential portion 3a and the support portion 3b may be separate bodies. The circumferential portion 3a and the support portion 3b may be separable. For example, the plate 3 includes a container body and the support portion 3b. The container body has the circumferential portion 3a. The support portion 3b is supported by the container body. The support portion 3b is separable from the container body.

(9) The nozzle 19 may be appropriately changed.

Although not illustrated, the number of ejection ports 19a included in one nozzle 19 may be less than five or more than five. The number of ejection ports 19a included in one nozzle 19 may be one.

For example, the ejection port 19a may have an annular shape. The ejection port 19a may extend in the circumferential direction of the vertical axis passing through the nozzle 19.

For example, the nozzle 19 may include a first nozzle and a second nozzle. The first nozzle is connected to the treating gas supply unit 11. The first nozzle is not connected to the inert gas supply unit 15. The first nozzle exclusively ejects the treating gas. The second nozzle is not connected to the treating gas supply unit 11. The second nozzle is connected to the inert gas supply unit 15. The second nozzle exclusively ejects the inert gas.

(10) The exhaust port 25 may be appropriately changed.

For example, the number of exhaust ports 25 provided in one treatment container 2 may be less than four or more than four. The number of exhaust ports 25 provided in one treatment container 2 may be one.

For example, the exhaust port 25 may have an annular shape. The exhaust port 25 may extend along the circumferential portion 3a of the plate 3.

(11) In the embodiment and the modifications described in the above (1) to (10), each configuration may be appropriately changed by being further replaced or combined with a configuration of another modification.

The present invention may be embodied in other specific forms without departing from the spirit or essential attributes thereof and, accordingly, reference should be made to the appended claims, rather than to the foregoing specification, as indicating the scope of the invention.

### Reference Signs List

1: Substrate processing apparatus
2: Treatment container (treatment chamber)
3: Plate (container body, chamber body)
11: Treating gas supply unit
15: Inert gas supply unit
19: Nozzle
19a: Ejection port
21: Exhaust unit
27: Substrate transporting mechanism
31: Controller
A: Treatment space
B: External space
D: Gap
G: Supply flow rate
GS: Supply flow rate of strong step
GW: Supply flow rate of weak step
H: Exhaust flow rate
HS: Exhaust flow rate of strong step
HW: Exhaust flow rate of weak step
J: Supply amount
JS: Supply amount of the single strong step
K: Exhaust amount
KW: Exhaust amount of the single weak step
S4: Treating step
S5: Replacing step
S6: Pressure restoration step
SS: Strong step
SS1: First strong step
SS2: Second strong step
SSF: Final strong step
SW: Weak step
SW1: First weak step
T: Time length
TS: Time length of the single strong step
TW: Time length of the single weak step
W: Substrate
Z: Vertical direction

## Claims

1. A substrate processing method comprising:
a treating step of supplying a treating gas to a treatment space accommodating a substrate;
a replacing step of supplying an inert gas to the treatment space and exhausting a gaseous body from the treatment space in a state where a pressure in the treatment space is kept lower than atmospheric pressure; and
a pressure restoration step of restoring the pressure in the treatment space to the atmospheric pressure, wherein
a flow rate of the inert gas supplied to the treatment space is defined as a supply flow rate,
a flow rate of the gaseous body exhausted from the treatment space is defined as an exhaust flow rate, and
in the replacing step, at least either the supply flow rate or the exhaust flow rate changes with time.

2. The substrate processing method according to claim 1, wherein
at least either the supply flow rate or the exhaust flow rate temporarily changes to zero in the replacing step.

3. The substrate processing method according to claim 1, wherein
the inert gas is intermittently supplied to the treatment space in the replacing step.

4. The substrate processing method according to claim 1, wherein
the gaseous body in the treatment space is intermittently exhausted in the replacing step.

5. The substrate processing method according to claim 1, wherein
the inert gas is supplied to the treatment space, and then both the supply flow rate and the exhaust flow rate simultaneously change to zero in the replacing step.

6. The substrate processing method according to claim 1, wherein
the replacing step includes
a strong step, and
a weak step,
the strong step and the weak step are alternately executed, and
at least either the supply flow rate or the exhaust flow rate is different between the strong step and the weak step.

7. The substrate processing method according to claim 6, wherein
the supply flow rate of the weak step is equal to or less than the supply flow rate of the strong step, and
the exhaust flow rate of the weak step is equal to or less than the exhaust flow rate of the strong step.

8. The substrate processing method according to claim 6, wherein
at least either the supply flow rate or the exhaust flow rate is zero in the weak step.

9. The substrate processing method according to claim 6, wherein
the supply flow rate is zero and the exhaust flow rate is zero in the weak step.

10. The substrate processing method according to claim 6, wherein
a time length of the single weak step is equal to or shorter than a time length of the single strong step.

11. The substrate processing method according to claim 6, wherein
a time length of the single weak step is equal to or shorter than half a time length of the single strong step.

12. The substrate processing method according to claim 6, wherein
a number of the strong steps included in the replacing step is two or more, and
a number of the weak steps included in the replacing step is one or more.

13. The substrate processing method according to claim 6, wherein
a number of the strong steps included in the replacing step is four or more, and
a number of the weak steps included in the replacing step is three or more.

14. The substrate processing method according to claim 6, wherein
an amount of the inert gas supplied to the treatment space is defined as a supply amount,
an amount of the gaseous body exhausted from the treatment space is defined as an exhaust amount, and
a difference between the supply amount and the exhaust amount in the single weak step is different from a difference between the supply amount and the exhaust amount in the single strong step.

15. The substrate processing method according to claim 6, wherein
the strong step performed first among a plurality of the strong steps is defined as a first strong step,
the weak step performed immediately after the first strong step is defined as a first weak step, and
a flow of the gaseous body in the treatment space in the first weak step is weaker than a flow of the gaseous body in the treatment space in the first strong step.

16. The substrate processing method according to claim 15, wherein
the strong step performed immediately after the first weak step is defined as a second strong step, and
a flow of the gaseous body in the treatment space in the second strong step is stronger than the flow of the gaseous body in the treatment space in the first weak step.

17. The substrate processing method according to claim 15, wherein
the strong step performed last among the plurality of strong steps is defined as a final strong step, and
a time length of the final strong step is longer than a time length of the first strong step.

18. The substrate processing method according to claim 17, wherein
the pressure in the treatment space in the final strong step is higher than the pressure in the treatment space in the first strong step.

19. A substrate processing apparatus comprising:
a treatment container configured to accommodate a substrate;
a treating gas supply unit connected to the treatment container and configured to supply a treating gas to the treatment container;
an inert gas supply unit connected to the treatment container and configured to supply an inert gas to the treatment container;
an exhaust unit connected to the treatment container and configured to exhaust a gaseous body from the treatment container; and
a controller configured to control the treating gas supply unit, the inert gas supply unit, and the exhaust unit to execute a treating operation for treating the substrate in the treatment container and a replacing operation for replacing the treating gas in the treatment container with the inert gas, wherein
in the treating operation, the treating gas supply unit supplies the treating gas to the treatment container,
in the replacing operation, the inert gas supply unit supplies the inert gas to the treatment container, and the exhaust unit exhausts the gaseous body from the treatment container, and
in the replacing operation, the controller controls the inert gas supply unit and the exhaust unit to time-dependently change an intensity of a flow of the gaseous body in the treatment container.

20. The substrate processing apparatus according to claim 19, wherein
the controller controls the inert gas supply unit and the exhaust unit to intermittently stop the flow of the gaseous body in the treatment container in the replacing operation.
